(19) **Europäisches Patentamt / European Patent Office / Office européen des brevets**

(11) **EP 4 564 684 A1**

(12) **EUROPEAN PATENT APPLICATION**
published in accordance with Art. 153(4) EPC

(43) Date of publication:
**04.06.2025 Bulletin 2025/23**

(21) Application number: **22954266.7**

(22) Date of filing: **08.08.2022**

(51) International Patent Classification (IPC):
*H03M 7/40* $^{(2006.01)}$

(52) Cooperative Patent Classification (CPC):
**H03M 7/40**

(86) International application number:
**PCT/CN2022/110968**

(87) International publication number:
**WO 2024/031286 (15.02.2024 Gazette 2024/07)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Huawei Technologies Co., Ltd.**
**Shenzhen, Guangdong 518129 (CN)**

(72) Inventors:
• **TONG, Jiajie**
  **Shenzhen, Guangdong 518129 (CN)**
• **ZHANG, Huazi**
  **Shenzhen, Guangdong 518129 (CN)**
• **WANG, Xianbin**
  **Shenzhen, Guangdong 518129 (CN)**
• **LI, Rong**
  **Shenzhen, Guangdong 518129 (CN)**
• **WANG, Jun**
  **Shenzhen, Guangdong 518129 (CN)**

(74) Representative: **Maiwald GmbH**
**Engineering**
**Elisenhof**
**Elisenstrasse 3**
**80335 München (DE)**

(54) **DATA PROCESSING METHOD, APPARATUS AND DEVICE**

(57) This application provides a data processing method, an apparatus, and a device. According to the method, a new encoding matrix G of a polar code is designed. When a terminal device encodes to-be-encoded information bits by using the encoding matrix G, after receiving a part of information bits in an encoding process, the terminal device may encode the part of information bits and send encoded data, to implement stream encoding and help reduce sizes of an encoder and a buffer in the terminal device. In addition, the to-be-encoded information bits are encoded by using the encoding matrix, to obtain the encoded data, which facilitates stream decoding and reduce a size of a decoder.

FIG. 3

**Description**

**TECHNICAL FIELD**

This application relates to the field of communication technologies, and in particular, to a data processing method, an apparatus, and a device.

**BACKGROUND**

A polar code (Polar code) is a channel encoding scheme that can be strictly proved to "reach" a Shannon channel capacity. The polar code features good performance, low complexity, and the like, and may be applied to a 5th generation (5th generation, 5G) communication system and a future communication system. The polar code is a linear block code, and encoded data may be generated by using an encoding matrix. Currently, the encoding matrix of the polar code determines that a device can start encoding or decoding only after receiving complete to-be-encoded data or to-be-decoded data.

**SUMMARY**

This application provides a data processing method, an apparatus, and a device. According to the method, a new encoding matrix of a polar code is designed, to implement stream encoding and/or stream decoding.

According to a first aspect, this application provides a first data processing method. The data processing method may be performed by a terminal device or a network device. An example in which the terminal device is an execution body and the terminal device is an encoding side is used. The terminal device obtains an information bit sequence, encodes the information bit sequence based on an encoding matrix $G$ to obtain encoded data, and then sends the encoded data. The encoding matrix G is represented as:

$$G = \begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix},$$

the encoding matrix $G$ is a matrix with a size of $(m \times 2^n) \times (m \times 2^n)$, $m$ and $n$ are positive integers, the matrix $G_{N'}$ is a polar generator matrix with a size of $2^n \times 2^n$, and a matrix $O$ is an all-zero matrix with a size of $2^n \times 2^n$.

According to the method, a new encoding matrix $G$ of a polar code is designed. When the terminal device encodes to-be-encoded information bits by using the encoding matrix $G$, after receiving a part of information bits in an encoding process, the terminal device may encode the part of information bits and send encoded data, to implement stream encoding and help reduce sizes of an encoder and a buffer in the terminal device. In addition, the to-be-encoded information bits are encoded by using the encoding matrix, to obtain the encoded data, which facilitates stream decoding.

In a possible implementation, the information bit sequence includes $m$ segments, and a polar generator matrix of each segment is $G_{N'}$.

According to the method, the information bit sequence may alternatively be divided into the $m$ segments, and a modulo two multiplication operation is performed on each segment and the matrix $G_{N'}$.

In a possible implementation, quantities of information bits in the $m$ segments are $k_0, k_1, \dots, k_{m-1}$, where $k_0$ is less than $k_{m-1}$, and $k_0 \leq k_1 \leq \dots \leq k_{m-1}$.

In a possible implementation, a quantity of information bits in an $i^{th}$ segment is $k_i$, where $i$ satisfies $0 \leq i \leq m - 1$.

According to the method, quantities of information bits in all segments are different, and change according to a specific quantity rule.

In a possible implementation, $m$ pieces of buffered data are obtained, where a $j^{th}$ piece of buffered data is obtained by encoding a $j^{th}$ segment of the information bit sequence by using the matrix $G_{N'}$, and $j$ satisfies $0 \leq j \leq m-1$; and the encoded data includes $m$ segments, a $0^{th}$ segment of encoded data is an $(m-1)^{th}$ piece of buffered data, an $i^{th}$ segment of encoded data is obtained by performing exclusive OR processing on a $j^{th}$ piece of buffered data and the $(m-1)^{th}$ piece of buffered data, $i$ satisfies $1 \leq i \leq m-1$, and $j$ satisfies $0 \leq j \leq m-2$.

In a possible implementation, the $(m-1)^{th}$ piece of buffered data is first sent; and then the $i^{th}$ segment of encoded data is successively sent, where $1 \leq i \leq m-1$.

According to the method, after the information bits in the $m$ segments are converted into the $m$ pieces of buffered data, the encoded data is sent in specified order.

In a possible implementation, elementary column transformation is performed on the encoding matrix $G$, where a

$$G' = \begin{bmatrix} O & G_{N'} & \dots & O \\ O & O & \dots & \dots \\ \dots & \dots & \ddots & G_{N'} \\ G_{N'} & G_{N'} & \dots & G_{N'} \end{bmatrix}$$

transformed encoding matrix ; and the information bit sequence is encoded based on the transformed encoding matrix $G'$, to obtain the encoded data.

According to the method, elementary column transformation is performed on the encoding matrix $G$, so that when the terminal device encodes the to-be-encoded information bits by using the transformed encoding matrix $G'$, stream encoding can also be implemented. This helps reduce the sizes of the encoder and the buffer in the terminal device.

In a possible implementation, quantities of information bits in the $m$ segments are $k_0, k_1, \dots, k_{m-1}$, where $k_1$ is less than $k_0$, and $k_1 \leq \dots \leq k_{m-1} \leq k_0$.

In a possible implementation, a quantity of information bits in an $i^{th}$ segment is $k_i$, where $i$ satisfies $0 \leq i \leq m$ -1.

According to the method, quantities of information bits included in all segments are different. It is assumed that first received $k_0$ information bits have a largest quantity (that is, a $0^{th}$ segment has a largest quantity of information bits), and the encoder separately encodes remaining m-1 segments based on encoded data corresponding to the first received $k_0$ information bits, to facilitate stream encoding.

In a possible implementation, the encoded data includes $m$ segments, a $0^{th}$ segment of encoded data is obtained by encoding a $0^{th}$ segment of the information bit sequence based on the matrix $G_{N'}$; and an $i^{th}$ segment of encoded data is obtained by encoding an $i^{th}$ segment of the information bit sequence based on the matrix $G_{N'}$ and then performing exclusive OR processing on the $i^{th}$ segment and the $0^{th}$ segment of encoded data.

According to the method, because the information bit sequence is divided into the $m$ segments, the encoded data corresponding to the $m$ segments is also divided into the $m$ segments. In this encoding scheme, the $0^{th}$ segment of encoded data is buffered, and exclusive OR processing (for example, information interleaving) is separately performed on the $0^{th}$ segment of encoded data and the remaining m-1 segments of encoded data, to support stream encoding.

According to a second aspect, this application provides a second data processing method. The data processing method may be performed by a terminal device or a network device. An example in which the terminal device is an execution body and the terminal device is an encoding side is used. The terminal device obtains an information bit sequence, where the information bit sequence includes $m$ segments, and processes each segment by using a polar generator matrix $G_{N'}$ of the segment, to obtain $m$ pieces of buffered data, where the matrix $G_{N'}$ is a polar generator matrix with a size of $2^n \times 2^n$. Then, the terminal device obtains and sends encoded data based on the $m$ pieces of buffered data. The encoded data includes $m$ segments, a $0^{th}$ segment of encoded data is an $(m-1)^{th}$ piece of buffered data, an $i^{th}$ segment of encoded data is obtained by performing exclusive OR processing on a $j^{th}$ piece of buffered data and the $(m-1)^{th}$ piece of buffered data, $i$ satisfies $1 \leq i \leq m$ -1, and satisfies $0 \leq j \leq m$-2.

According to the method, the terminal device divides the to-be-encoded information bit sequence into the $m$ segments, performs encoding and information interleaving on each segment by using the polar generator matrix with the size of $2^n \times 2^n$, and sends the encoded data in an interleaved manner, to facilitate stream decoding.

In a possible implementation, quantities of information bits in the $m$ segments are $k_0, k_1, \dots, k_{m-1}$, where $k_0$ is less than $k_{m-1}$, and $k_0 \leq k_1 \leq \dots \leq k_{m-1}$.

In a possible implementation, a quantity of information bits in an $i^{th}$ segment is $k_i$, where $i$ satisfies $0 \leq i \leq m$ - 1.

In a possible implementation, the terminal device may encode the information bit sequence based on an

$$G = \begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix}$$

encoding matrix $G$ to obtain the encoded data. The encoding matrix , the encoding matrix $G$ is a matrix with a size of $(m \times 2^n)) \times (m \times 2^n)$, $m$ and $n$ are positive integers, the matrix $G_{N'}$ is the polar generator matrix with the size of $2^n \times 2^n$, and a matrix $O$ is an all-zero matrix with a size of $2^n \times 2^n$.

According to the method, the encoding matrix based on the polar generator matrix is designed, which is similar to constructing a coupling matrix of the polar generator matrix, to facilitate stream decoding with the encoding matrix $G$.

According to a third aspect, this application provides a third data processing method. The data processing method may be performed by a terminal device or a network device. An example in which the terminal device is an execution body and the terminal device is an encoding side is used. The terminal device obtains an information bit sequence, where the information bit sequence includes $m$ segments, and processes each segment by using a polar generator matrix $G_{N'}$ of the segment, to obtain and send encoded data. The matrix $G_{N'}$ is a polar generator matrix with a size of $2^n \times 2^n$, the encoded data includes $m$ segments, a $0^{th}$ segment of encoded data is obtained by encoding a $0^{th}$

segment of the information bit sequence based on the matrix $G_{N'}$, and an $i^{th}$ segment of encoded data is obtained by encoding an $i^{th}$ segment of the information bit sequence based on the matrix $G_{N'}$ and then performing exclusive OR processing on the $i^{th}$ segment and the $0^{th}$ segment of encoded data.

According to the method, the terminal device divides the to-be-encoded information bit sequence into the $m$ segments, and performs encoding and information interleaving on each segment by using the polar generator matrix with the size of $2^n \times 2^n$. In this way, after receiving a part of information in an encoding process, the terminal device can encode and send the part of information (that is, to support stream encoding), to reduce sizes of an encoder and a buffer.

In a possible implementation, quantities of information bits in the $m$ segments are $k_0, k_1, \ldots, k_{m-1}$, where $k_1$ is less than $k_0$, and $k_1 \leq \ldots \leq k_{m-1} \leq k_0$.

In a possible implementation, a quantity of information bits in an $i^{th}$ segment is $k_i$, where $i$ satisfies $0 \leq i \leq m-1$.

In a possible implementation, the terminal device may encode the information bit sequence based on an

$$G' = \begin{bmatrix} O & G_{N'} & \ldots & O \\ O & O & \ldots & \ldots \\ \ldots & \ldots & \ddots & G_{N'} \\ G_{N'} & G_{N'} & \ldots & G_{N'} \end{bmatrix}$$

encoding matrix $G'$ to obtain the encoded data. The encoding matrix , the encoding matrix $G'$ is a matrix with a size of $(m \times 2^n) \times (m \times 2^n)$, $m$ and $n$ are positive integers, the matrix $G_{N'}$ is the polar generator matrix with the size of $2^n \times 2^n$, and a matrix $O$ is an all-zero matrix with a size of $2^n \times 2^n$.

According to the method, the encoding matrix based on the polar generator matrix is designed, which is similar to constructing a coupling matrix of the polar generator matrix, to facilitate stream encoding with the encoding matrix $G'$.

It should be noted that the methods in the first aspect to the third aspect may alternatively be performed by the network device. In this case, the network device is an encoding side, and the terminal device is a decoding side.

According to a fourth aspect, this application provides a fourth data processing method. The data processing method may be performed by a terminal device or a network device. An example in which the network device is an execution body and the network device is a decoding side is used. The network device receives encoded data, and decodes the encoded data to obtain decoded data. The encoded data is obtained by encoding an information bit sequence

$$G = \begin{bmatrix} G_{N'} & O & \ldots & O \\ O & G_{N'} & \ldots & O \\ \ldots & \ldots & \ddots & \ldots \\ G_{N'} & G_{N'} & \ldots & G_{N'} \end{bmatrix}$$

based on an encoding matrix $G$, the encoding matrix , the encoding matrix $G$ is a matrix with a size of $(m \times 2^n) \times (m \times 2^n)$, $m$ and $n$ are positive integers, a matrix $G_{N'}$ is a polar generator matrix with a size of $2^n \times 2^n$, and a matrix $O$ is an all-zero matrix with a size of $2^n \times 2^n$.

According to the method, because the encoded data is obtained based on a new encoding matrix $G$ of a polar code designed in this application, after receiving the encoded data, the decoding side may support decoding of a part of information after receiving the part of information in a decoding process, to reduce a size of a decoder.

In a possible implementation, the information bit sequence includes $m$ segments, and a polar generator matrix of each segment is $G_{N'}$.

In a possible implementation, the network device obtains marked data corresponding to a $0^{th}$ segment of encoded data and marked data corresponding to a $1^{st}$ segment of encoded data; performs an F operation on the marked data corresponding to the $0^{th}$ segment of encoded data and the marked data corresponding to the $1^{st}$ segment of encoded data, to obtain marked data corresponding to the $1^{st}$ segment of encoded data after the F operation; performs polar code decoding on the marked data corresponding to the $1^{st}$ segment of encoded data after the F operation, to obtain decoded data corresponding to the $1^{st}$ segment of encoded data; and then enhances, based on the marked data corresponding to the $1^{st}$ segment of encoded data and the decoded data corresponding to the $1^{st}$ segment of encoded data, the marked data corresponding to the $0^{th}$ segment of encoded data. It should be noted that the $0^{th}$ segment of encoded data includes last $N'$ columns of the encoding matrix $G$, or the $0^{th}$ segment of encoded data includes first $N'$ columns of an encoding matrix $G'$ obtained by performing elementary column transformation on first $(m-1) \times 2^n$ columns and last $2^n$ columns of the encoding matrix $G$. The $1^{st}$ segment of encoded data includes first $N'$ columns of the encoding matrix $G$, or the $1^{st}$ segment of encoded data includes first $N'+1$ columns to first $N'^*2$ columns of the encoding matrix $G'$.

According to the method, the network device performs decoding based on the $0^{th}$ segment of encoded data that is received for the first time and the adjacent $1^{st}$ segment of encoded data, to implement stream decoding. In addition, the $0^{th}$ segment of encoded data is enhanced, which facilitates stream decoding based on the enhanced $0^{th}$ segment of encoded data in a subsequent decoding process.

In a possible implementation, the network device continues to obtain marked data corresponding to a $q^{th}$

segment of encoded data, where $q$ is $2 \leq q \leq m-1$; performs an F operation on the marked data corresponding to the $q^{th}$ segment of encoded data and enhanced marked data corresponding to the $0^{th}$ segment of encoded data, to obtain marked data corresponding to the $q^{th}$ segment of encoded data after the F operation; performs polar code decoding on the marked data corresponding to the $q^{th}$ segment of encoded data after the F operation, to obtain decoded data corresponding to the $q^{th}$ segment of encoded data; and enhances, based on the marked data corresponding to the $q^{th}$ segment of encoded data and the decoded data corresponding to the $q^{th}$ segment of encoded data, the enhanced marked data corresponding to the $0^{th}$ segment of encoded data.

According to the method, a $2^{nd}$ segment of encoded data to an $(m-1)^{th}$ segment of encoded data are decoded by using a same method. In addition, as decoding is performed, the marked data corresponding to the $0^{th}$ segment of encoded data is continuously enhanced, which facilitates stream decoding.

It should be noted that the method in the fourth aspect may alternatively be performed by the terminal device. In this case, the network device is an encoding side, and the terminal device is a decoding side.

According to a fifth aspect, an embodiment of this application provides a data processing apparatus. The data processing apparatus may be a terminal device, or may be an apparatus in the terminal device, or may be an apparatus that can be used with the terminal device. In a design, the data processing apparatus may include a one-to-one corresponding module for performing the method/operation/step/action described in any one of the first aspect to the third aspect or the possible implementations of the first aspect to the third aspect. The module may be a hardware circuit, or may be software, or may be implemented by a combination of a hardware circuit and software. In a design, the data processing apparatus may include a processing unit and a communication unit.

For specific descriptions of the method/operation/step/action performed by the terminal device, refer to the corresponding descriptions in any one of the first aspect to the third aspect or the possible implementations of the first aspect to the third aspect. Details are not described herein again. It may be understood that the data processing apparatus can also achieve effects that can be achieved in the first aspect to the third aspect.

According to a sixth aspect, an embodiment of this application provides a data processing apparatus. The data processing apparatus may be a network device, or may be an apparatus in the network device, or may be an apparatus that can be used with the network device. In a design, the data processing apparatus may include a one-to-one corresponding module for performing the method/operation/step/action described in any one of the fourth aspect or the possible implementations of the fourth aspect. The module may be a hardware circuit, or may be software, or may be implemented by a combination of a hardware circuit and software. In a design, the data processing apparatus may include a processing unit and a communication unit.

For specific descriptions of the method performed by the network device, refer to the corresponding descriptions in any one of the fourth aspect or the possible implementations of the fourth aspect. Details are not described herein again. It may be understood that the data processing apparatus can also achieve effects that can be achieved in the fourth aspect.

According to a seventh aspect, an embodiment of this application provides a communication apparatus. The communication apparatus includes an input/output interface and a logic circuit. The input/output interface is configured to input or output data. The logic circuit processes the data according to the method in any one of the first aspect to the third aspect or the possible implementations of the first aspect to the third aspect, to obtain processed data.

According to an eighth aspect, an embodiment of this application provides a communication apparatus. The communication apparatus includes an input/output interface and a logic circuit. The input/output interface is configured to input or output data. The logic circuit processes the data according to the method in any one of the fourth aspect or the possible implementations of the fourth aspect, to obtain processed data.

According to a ninth aspect, an embodiment of this application provides a terminal device, including a processor, where the processor is coupled to a memory, the memory is configured to store instructions, and when the instructions are executed by the processor, the terminal device is enabled to implement the method in any one of the first aspect to the fourth aspect or the possible implementations of the first aspect to the fourth aspect.

According to a tenth aspect, an embodiment of this application provides a network device, including a processor, where the processor is coupled to a memory, the memory is configured to store instructions, and when the instructions are executed by the processor, the network device is enabled to implement the method in any one of the first aspect to the fourth aspect or the possible implementations of the first aspect to the fourth aspect.

According to an eleventh aspect, an embodiment of this application provides a communication system. The communication system includes a transmitting end and a receiving end. The transmitting end is configured to implement a function in the method in any one of the first aspect to the third aspect or the possible implementations of the first aspect to the third aspect. The receiving end is configured to implement a function in the method in any one of the fourth aspect or the possible implementations of the fourth aspect. Optionally, the communication system may include the data processing apparatuses described in the fifth aspect and the sixth aspect, or may include the communication apparatuses described in the seventh aspect and the eighth aspect, or may include the devices described in the ninth aspect and the tenth aspect.

According to a twelfth aspect, an embodiment of this application further provides a computer-readable storage medium. The computer-readable storage medium stores instructions, and when the instructions are run on a computer, the computer is enabled to perform the method in any one of the first aspect to the fourth aspect or the possible implementations of the first aspect to the fourth aspect.

According to a thirteenth aspect, an embodiment of this application provides a chip system. The chip system includes a processor, and may further include a memory, configured to implement a function in the method in any one of the first aspect to the fourth aspect or the possible implementations of the first aspect to the fourth aspect. The chip system may include a chip, or may include a chip and another discrete component.

According to a fourteenth aspect, an embodiment of this application further provides a computer program product, including instructions. When the instructions are run on a computer, the computer is enabled to perform the method in any one of the first aspect to the fourth aspect or the possible implementations of the first aspect to the fourth aspect.

**BRIEF DESCRIPTION OF DRAWINGS**

FIG. 1 is a diagram of a communication system according to this application;
FIG. 2 is a diagram of encoding a polar code of $8 \times 8$;
FIG. 3 is a schematic flowchart of a data processing method according to this application;
FIG. 4 is a diagram of stream encoding supporting stream decoding according to this application;
FIG. 5 is a diagram of stream encoding according to this application;
FIG. 6 is a schematic flowchart of another data processing method according to this application;
FIG. 7 is a diagram of stream decoding according to this application;

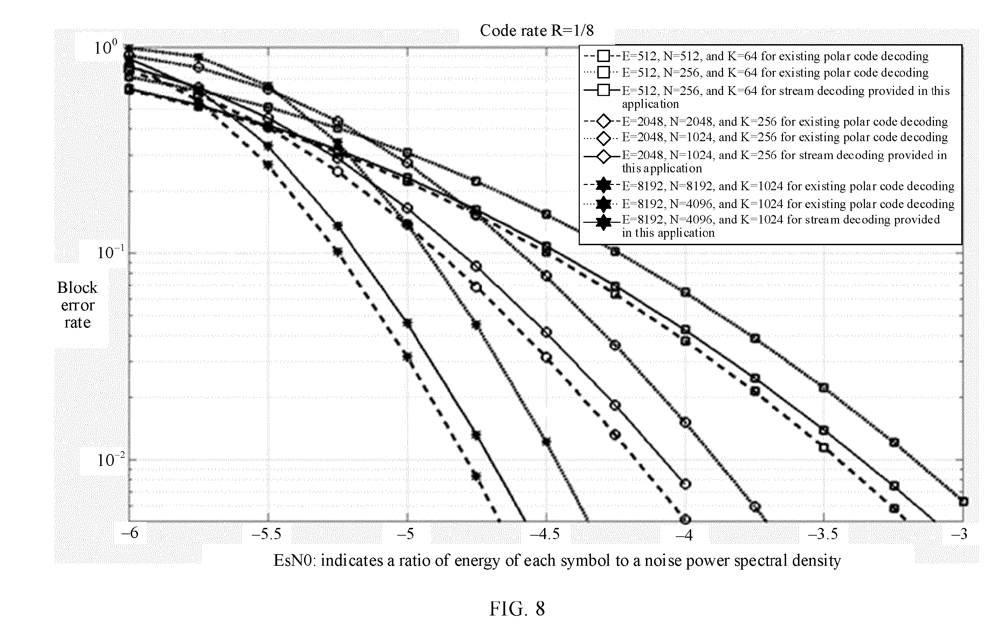

FIG. 8 is a performance analysis diagram of a data processing method according to this application;
FIG. 9 is a diagram of an apparatus according to this application; and
FIG. 10 is a diagram of a communication device according to this application.

**DESCRIPTION OF EMBODIMENTS**

In this application, "/" may represent an "or" relationship between associated objects. For example, A/B may represent A or B. In addition, "and/or" may indicate that there are three relationships between associated objects. For example, A and/or B may represent the following three cases: Only A exists, both A and B exist, and only B exists, where A and B may be singular or plural. For ease of description of technical solutions of this application, in this application, terms such as "first" and "second" may be used to distinguish between technical features with same or similar functions. The terms such as "first" and "second" do not limit a quantity and an execution sequence, and the terms such as "first" and "second" do not limit a definite difference. In this application, the terms such as "example" or "for example" is used to represent an example, an illustration, or a description. Any embodiment or design scheme described as "example" or "for example" should not be explained as being more preferred or having more advantages than another embodiment or design scheme. The terms such as "example" or "for example" is used to present a related concept in a specific manner for ease of understanding.

The following describes the technical solutions of this application with reference to the accompanying drawings in this application.

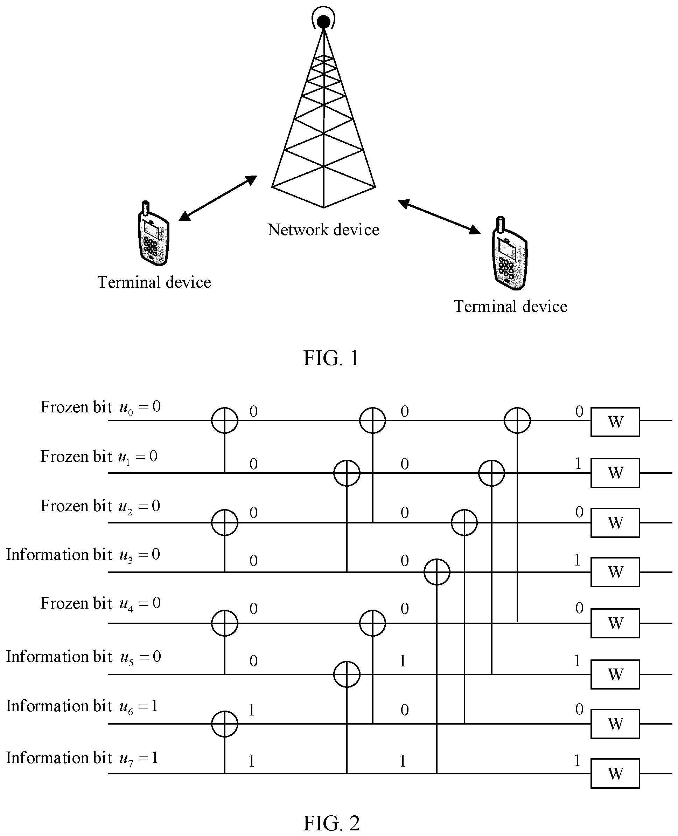

This application provides a data processing method. According to the method, a new encoding matrix of a polar code is constructed, and to-be-encoded information bits are processed by using the encoding matrix, to implement stream encoding and/or stream decoding of the polar code. The data processing method may be applied to a communication system, and a system architecture is shown in FIG. 1. The communication system includes a network device and a terminal device, and the network device may provide a communication service for the terminal device.

The communication system mentioned in this application includes but is not limited to: a narrowband-internet of things (narrowband-Internet of things, NB-IoT) system, a global system for mobile communications (global system for mobile communications, GSM), an enhanced data rate for GSM evolution (enhanced data rate for GSM evolution, EDGE) system, a wideband code division multiple access (wideband code division multiple access, WCDMA) system, a code division multiple access 2000 (code division multiple access, CDMA2000) system, a time division-synchronization code division multiple access (time division-synchronization code division multiple access, TD-SCDMA) system, a long term evolution (long term evolution, LTE) system, three application scenarios of a 5G mobile communication system: enhanced mobile broadband (enhanced mobility broad band, eMBB), ultra-reliable and low-latency communications (ultra-reliable and low-latency communications, URLLC), and enhanced machine-type communication (enhanced machine-type communication, eMTC), and a future communication system (such as 6G/7G).

The network device may be a device that can communicate with the terminal device. The network device may be a base station, a relay station, or an access point. The base station may be a base transceiver station (base transceiver station, BTS) in a global system for mobile communications (global system for mobile communications, GSM) or a code division multiple access (code division multiple access, CDMA) network, or may be a 3G base station NodeB in a wideband code division multiple access (wideband code division multiple access, WCDMA) system, or may be an evolutional NodeB (eNB or eNodeB for short) in a long term evolution (long term evolution, LTE) system. The network device may alternatively be a satellite in a satellite communication system. The network device may alternatively be a radio controller in a cloud radio access network (cloud radio access network, CRAN) scenario. The network device may alternatively be a network device in a 5G network or a network device (for example, a gNodeB) in a future evolved public land mobile network (public land mobile network, PLMN) network. The network device may alternatively be a wearable device, an uncrewed aerial vehicle, a device in the internet of vehicles (for example, a vehicle to everything (vehicle to everything, V2X) device), a communication device in device to device (device to device, D2D) communication, or a network device used in a future communication system.

The terminal device may be user equipment (user equipment, UE), an access terminal, a terminal unit, a terminal station, a mobile station, a remote station, a remote terminal, a mobile device, a terminal, a wireless communication device, a terminal agent, a terminal apparatus, or the like. The access terminal may be a cellular phone, a cordless phone, a session initiation protocol (session initiation protocol, SIP) phone, a wireless local loop (wireless local loop, WLL) station, a personal digital assistant (personal digital assistant, PDA), a handheld device with a wireless communication function, a computing device, another processing device connected to a wireless modem, a wearable device, an uncrewed aerial vehicle, a V2X device, a D2D device, a terminal device in the 5G network, a terminal device in the future evolved PLMN network, a terminal device in the future communication system, or the like.

It may be understood that this application is an encoding scheme, and may be used for a dedicated network device or a general-purpose device, may be used for the network device, or may be used for various terminal devices or the like. This application may be implemented by using a dedicated chip (for example, an application-specific integrated circuit (application-specific integrated circuit, ASIC)), or may be implemented by using a programmable chip (for example, a field programmable gate array (field programmable gate array, FPGA)), or may be implemented by using software (program code in a memory). This is not limited in this application.

(1) Related concepts in this application

1. Polar code:

The polar code is a channel encoding scheme that can be strictly proved to reach a channel capacity. The polar code features high performance, low complexity, a flexible matching manner, and the like. Currently, the polar code has been determined as an uplink and/or downlink control channel encoding scheme in a 5th generation mobile communication (5th generation, 5G) control channel enhanced mobile broadband (enhanced mobile broadband, eMBB) scenario.

For example, FIG. 2 is a diagram of encoding a polar code of $8 \times 8$. To-be-encoded bits are sorted based on reliability of the to-be-encoded bits, and are successively arranged at different locations in a to-be-encoded block. Generally, a bit with high reliability is set as an information bit (data), and a bit with low reliability is set as a frozen (frozen) bit. A value of the frozen bit is usually set to 0, and is known to both a transmitting end and a receiving end during actual transmission. As shown in FIG. 2, $u_7, u_6, u_3, u_3$ are four bits with higher reliability and are respectively set as information bits, and $u_4, u_2, u_1, u_0$ are four bits with lower reliability and are respectively set as frozen bits.

The polar code is a linear block code. A generator matrix of the polar code is $G_N$, and an encoding process of the polar code is $x_1^N = u_1^N G_N$. $u_1^N = (u_1, u_2, ..., u_N)$ is a binary row vector, and has a length of $N$ (that is, a code length).

$G_N$ is a matrix of $N \times N$, and $G_N = F_2^{\otimes(\log_2(N))}$, where $F_2 = \begin{bmatrix} 1 & 0 \\ 1 & 1 \end{bmatrix}$, and $F_2^{\otimes(\log_2(N))}$ is defined as a Kronecker (Kronecker) product of $\log_2(N)$ matrices $F_2$. For example, when $N=4$, $\log_2(N) = \log_2(4) = 2$, and

$$F_2^{\otimes 2} = \begin{bmatrix} 1 & 0 & 0 & 0 \\ 1 & 1 & 0 & 0 \\ 1 & 0 & 1 & 0 \\ 1 & 1 & 1 & 1 \end{bmatrix}$$

; or when $N=8$, $\log_2(N) = \log_2 (8) = 3$, and

$$F_2^{\otimes 3} = \begin{bmatrix} 1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1 \end{bmatrix}$$ . Therefore, a standard mother code length of the polar code is $N = 2^n$, where n is a positive integer.

2. Encoding matrix $G$ provided in this application:

$$G = \begin{bmatrix} G_{N'} & 0 & \ldots & 0 \\ 0 & G_{N'} & \ldots & 0 \\ \ldots & \ldots & \ddots & \ldots \\ G_{N'} & G_{N'} & \ldots & G_{N'} \end{bmatrix}$$

The encoding matrix provided in this application is , $G$ is a matrix with a size of $(m \times 2^n) \times (m \times 2^n)$ $m$ and $n$ are positive integers, a matrix $G_{N'}$ is a polar generator matrix with a size of $2^n \times 2^n$, and is

represented as $G_{N'} = F_2^{\otimes\left(\log_2(N')\right)}$ , and a matrix $O$ is an all-zero matrix with a size of $2^n \times 2^n$.

In other words, if the encoding matrix G is considered as a matrix of $m \times m$, each element in the matrix is a matrix of $2^n \times 2^n$, each element in a diagonal of the matrix is a matrix $G_{N'}$, each element in a bottom edge of the matrix is a matrix $G_{N'}$, and an element other than the elements in the diagonal and the bottom edge is a matrix $O$.

A mother code length of the encoding matrix G is $N' = m \times 2^n$. It may be understood that when $m=1$ or $m=2$, the encoding matrix G is the same as an encoding matrix of an ordinary polar code. When $m \geq 3$, the encoding matrix

$$G = \begin{bmatrix} G_{N'} & 0 & \ldots & 0 \\ 0 & G_{N'} & \ldots & 0 \\ \ldots & \ldots & \ddots & \ldots \\ G_{N'} & G_{N'} & \ldots & G_{N'} \end{bmatrix}$$ .

3. Another encoding matrix $G'$ provided in this application:

Elementary column transformation may be performed on the encoding matrix G, to obtain the transformed

$$G' = \begin{bmatrix} O & G_{N'} & \ldots & O \\ O & O & \ldots & \ldots \\ \ldots & \ldots & \ddots & G_{N'} \\ G_{N'} & G_{N'} & \ldots & G_{N'} \end{bmatrix}$$

encoding matrix . It may be understood that elementary column transformation may be performed on first $(m-1) \times 2^n$ columns and last $2^n$ columns of the encoding matrix G, to obtain the encoding matrix G'. Same as the encoding matrix G, the encoding matrix G' is a matrix with the size of $(m \times 2^n) \times (m \times 2^n)$, m and n are positive integers, the matrix $G_{N'}$ is the polar generator matrix with the size of $2^n \times 2^n$, and is represented as $G_{N'} = F_2^{\otimes\left(\log_2(N')\right)}$ , the matrix $O$ is the all-zero matrix with the size of $2^n \times 2^n$, and a mother code length of the encoding matrix G' is $N' = m \times 2^n$.

4. F operation:

The F operation is a basic decoding operation of the polar code, and a predefined F function (f-function) is used for processing. Inputs of the F function are $L_0$, and $L_1$, and the F function may be simplified as:

$$f\left(L_0, L_1\right) = \left(\mathrm{sig}\left(L_0\right) \wedge \mathrm{sig}\left(L_1\right)?-1:1\right) * \left(\mathrm{abs}\left(L_0\right) > \mathrm{abs}\left(L_1\right)?\mathrm{abs}\left(L_1\right):\mathrm{abs}\left(L_0\right)\right).$$

sig indicates a sign operation. If an immediate number is greater than 0, a return value is 0. If an immediate number is not greater than 0, a return value is 1. abs indicates an absolute value operation. For example, it is assumed that there is encoded data $x_0$, and $x_{m-1}$ with a length of $N'$, an F operation is performed on $x_0$, and $x_{m-1}$, and signs of $x_0$, and $x_{m-1}$ are compared. If the signs are consistent, a value of the immediate number is 1. If the signs are not consistent, a value of the immediate number is -1.

5. G operation:

The G operation is a basic decoding operation of the polar code, and a predefined G function (g-function) is used for processing. Inputs of the G function are $L_0$, $L_1$, and a feedback value B, and the G function is $g(L_0, L_1, B) = (B==0)?L_1 + L_0 : L_1 - L_0$.

(2) Data processing method for implementing stream encoding provided in this application

1. Procedure of implementing stream encoding by using the encoding matrix *G*:

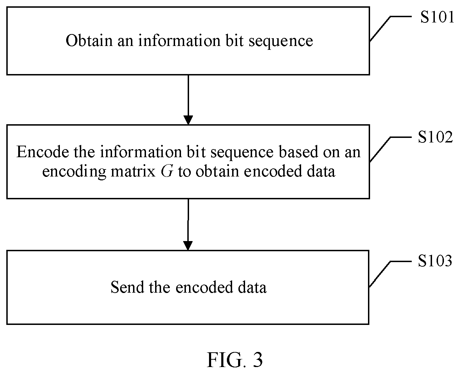

FIG. 3 is a schematic flowchart of a data processing method according to this application. The data processing method may be performed by a terminal device, or may be performed by a network device, an encoding procedure is mainly performed, and the following steps are included.
S101: Obtain an information bit sequence.
The information bit sequence includes a plurality of to-be-encoded information bits. For example, the information bit sequence may be represented as $\{a_0, a_1, a_2, \dots, a_{k-1}\}$, and one element in the information bit sequence represents one to-be-encoded bit. It may be understood that a length of the information bit sequence may not be a specified code length (for example, the length is not $m \times 2^n$), and the information bit sequence may be processed (for example, a frozen bit is inserted into the information bit sequence), so that a length of encoded data obtained by encoding the information bit sequence is $N' = m \times 2^n$.
It may be further understood that the to-be-encoded bits in this application may further include a cyclic redundancy check (cyclic redundancy check, CRC) bit and/or a parity check (parity check, PC) bit, and may further involve an operation such as scrambling some bits or even all bits. Because this is not related to the essence of the solution in this application, the to-be-encoded bits are used for unified description. Details are not described herein.
S102: Encode the information bit sequence based on an encoding matrix *G* to obtain encoded data.
For descriptions of the encoding matrix G, refer to the foregoing related concepts. Details are not described herein again. The following describes an encoding process by using an example. It is assumed that the information bit sequence is $u = \{a_0, a_1, a_2, \dots, a_{k-1}\}$, and the encoding process may be represented as:

$$x^N = u^N \times \begin{bmatrix} G_{N'} & 0 & \dots & 0 \\ 0 & G_{N'} & \dots & 0 \\ \dots & \dots & \ddots & \dots \\ G_{N'} & G_{N'} & \dots & G_{N'} \end{bmatrix} \qquad (1)$$

$u^N$ is the information bit sequence, modulo two multiplication is performed on $u^N$ and the encoding matrix G to obtain the encoded data $x^N$, and a length of $x^N$ is $m \times 2^n$.
In a possible implementation, the information bit sequence may be divided into $m$ segments, that is, the information bit sequence includes the $m$ segments, and a polar generator matrix of each segment is $G_{N'}$. A length of each segment is $2^n$. In this case, modulo two multiplication may be performed on each segment and the polar generator matrix $G_{N'}$ with a size of $2^n \times 2^n$, and information interleaving may be performed between segments, to obtain the encoded data. Specifically, two cases are included in this implementation in which the information bit sequence is encoded to obtain the encoded data.

Case 1: Quantities of information bits in the $m$ segments are $k_0, k_1, \ldots, k_{m-1}$, where $k_0$ is less than $k_{m-1}$, and $k_0 \leq k_1 \leq \ldots \leq k_{m-1}$.

$k_0$ is a quantity of information bits in a $0^{th}$ segment, $k_1$ is a quantity of information bits in a $1^{st}$ segment, and by analogy, $k_{m-1}$ is a quantity of information bits in an $(m-1)^{th}$ segment. In addition, the quantity of information bits in the $0^{th}$ segment is less than the quantity of information bits in the $(m-1)^{th}$ segment, and the $(m-1)^{th}$ segment has a largest quantity of information bits (that is, a last segment includes a largest quantity of information bits). In this case, the encoding process includes the following steps:

obtain $m$ pieces of buffered data, where a $j^{th}$ piece of buffered data is obtained by encoding a $j^{th}$ segment of the information bit sequence by using the matrix $G_{N'}$, and $j$ satisfies $0 \leq j \leq m-1$;
the encoded data includes $m$ segments;
a $0^{th}$ segment of encoded data is an $(m-1)^{th}$ piece of buffered data; and
an $i^{th}$ segment of encoded data is obtained by performing exclusive OR processing on the $j^{th}$ piece of buffered data and the $(m-1)^{th}$ piece of buffered data, $i$ satisfies $1 \leq i \leq m-1$, and $j$ satisfies $0 \leq j \leq m-2$.

For example, the terminal device first separately performs a modulo two multiplication operation on each segment of the information bit sequence by using the matrix $G_{N'}$, to obtain the $m$ pieces of buffered data, and then separately performs exclusive OR processing (for example, a modulo two addition operation) on the $(m-1)^{th}$ piece of buffered data and first m-2 pieces of buffered data, to obtain the encoded data.

It may be understood that an encoding principle of encoding the information bit sequence by using the encoding process described in the case 1 is similar to that of encoding the information bit sequence by using the encoding matrix $G$.

Case 2: Quantities of information bits in the $m$ segments are $k_0, k_1, \ldots, k_{m-1}$, where $k_1$ is less than $k_0$, and $k_1 \leq \ldots \leq k_{m-1} \leq k_0$.

$k_0$ is a quantity of information bits in a $0^{th}$ segment, $k_1$ is a quantity of information bits in a $1^{st}$ segment, and by analogy, $k_{m-1}$ is a quantity of information bits in an $(m-1)^{th}$ segment. In addition, the quantity of information bits in the $0^{th}$ segment is greater than the quantity of information bits in the $1^{st}$ segment, and the $0^{th}$ segment has a largest quantity of information bits (that is, the $1^{st}$ segment includes a largest quantity of information bits). In this case, the encoded data includes $m$ segments; a $0^{th}$ segment of encoded data is obtained by encoding a $0^{th}$ segment of the information bit sequence based on the matrix $G_{N'}$; and an $i^{th}$ segment of encoded data is obtained by encoding an $i^{th}$ segment of the information bit sequence based on the matrix $G_{N'}$ and then performing exclusive OR processing on the $i^{th}$ segment and the $0^{th}$ segment of encoded data.

For example, the terminal device first performs a modulo two multiplication operation on the $0^{th}$ segment of the information bit sequence by using the matrix $G_{N'}$, to obtain the $0^{th}$ segment of encoded data, then performs a modulo two multiplication operation on the $1^{st}$ segment of the information bit sequence by using the matrix $G_{N'}$, and performs exclusive OR processing (for example, a modulo two addition operation) on an operation result and the $0^{th}$ segment of encoded data, to obtain a $1^{st}$ segment of encoded data, and so on, until an $(m-1)^{th}$ segment of encoded data is obtained. It may be understood that the foregoing encoding process may be considered as a stream encoding process, that is, the encoder may receive to-be-encoded data while encoding received to-be-encoded data and then send encoded data.

Optionally, the encoding matrix $G'$ corresponding to the encoding process described in the case 2 is obtained by performing elementary column transformation on the encoding matrix $G$, where the encoding matrix

$$G' = \begin{bmatrix} O & G_{N'} & \ldots & O \\ O & O & \ldots & \ldots \\ \ldots & \ldots & \ddots & G_{N'} \\ G_{N'} & G_{N'} & \ldots & G_{N'} \end{bmatrix}$$

. In other words, an encoding principle of encoding the information bit sequence by using the encoding process described in the case 2 is similar to that of encoding the information bit sequence by using the encoding matrix $G$.

S103: Send the encoded data.

If the encoding procedure described in S102 can implement stream encoding (for example, the case 2 described in S102), after completing a segment of encoded data, the terminal device may send the segment of encoded data, and does not need to wait for all bits in the information bit sequence to be encoded before sending all encoded data. If the encoding procedure described in S102 is designed to implement stream decoding (for example, the case 1 described in S102), the terminal device sends all encoded data after all bits in the information bit sequence are encoded.

It can be learned that, in the data processing method provided in this application, a new encoding matrix $G$ of a polar code is designed. When the terminal device encodes to-be-encoded information bits by using the encoding matrix $G$,

after receiving a part of information bits in an encoding process, the terminal device may encode the part of information bits and send encoded data, to implement stream encoding and help reduce sizes of an encoder and a buffer in the terminal device. In addition, the to-be-encoded information bits are encoded by using the encoding matrix, to obtain the encoded data, which facilitates stream decoding.

2. Stream encoding process supporting stream decoding

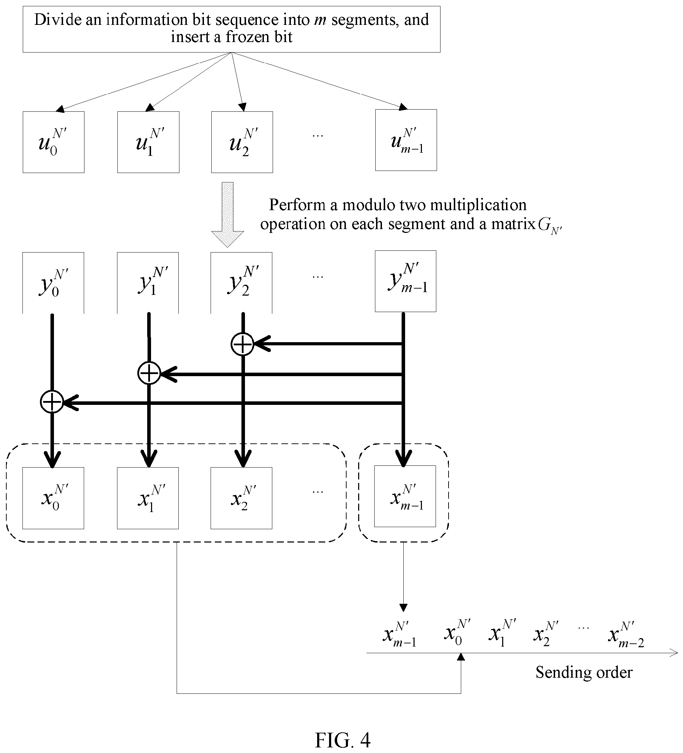

FIG. 4 is a diagram of stream encoding supporting stream decoding according to this application. An information bit sequence may be represented as $\{a_0,a_1,a_2,...,a_{k-1}\}$, and one element in the information bit sequence represents one to-be-encoded bit. The information bit sequence is divided into $m$ segments, and $k_i$ information bits are allocated to each segment. A frozen bit is inserted into first received $k_0$ information bits $\{a_0,a_1,a_2,...,a_{k0-1}\}$ to obtain $u_0^{N'}$, a modulo two multiplication operation is performed on $u_0^{N'}$ and the matrix $G_{N'}$ to obtain $y_0^{N'}$, and $y_0^{N'}$ is retained in a buffer. $y_1^{N'} \sim y_{m-1}^{N'}$ may be obtained by using a same processing procedure for the $k_0$ information bits, and $y_1^{N'} \sim y_{m-1}^{N'}$ are retained in the buffer.

It should be noted that an order of sending $y_1^{N'} \sim y_{m-1}^{N'}$ is as follows:

First, $y_{m-1}^{N'}$ is assigned to $x_{m-1}^{N'}$ and is sent.

Then, exclusive OR is performed on $y_0^{N'}$ and $y_{m-1}^{N'}$ to obtain and send $x_0^{N'}$.

Next, exclusive OR is performed on $y_1^{N'}$ and $y_{m-1}^{N'}$ to obtain and send $x_1^{N'}$.

By analogy, exclusive OR is performed on $y_{m-2}^{N'}$ and $y_{m-1}^{N'}$ to obtain and send $x_{m-2}^{N'}$.

After sending is completed in the foregoing order, the stream encoding process is completed.

3. Procedure supporting stream encoding

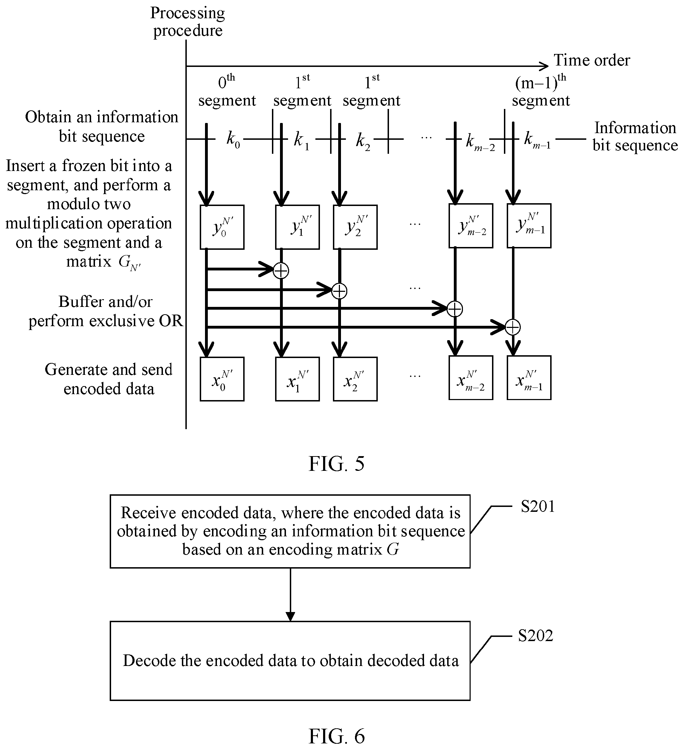

FIG. 5 is a diagram of stream encoding according to this application. An information bit sequence may be represented as $\{a_0,a_1,a_2,...,a_{k-1}\}$, and one element in the information bit sequence represents one to-be-encoded bit. The information bit sequence is divided into $m$ segments, and $k_i$ information bits are allocated to each segment. A frozen bit is inserted into first received $k_0$ information bits $\{a_0,a_1,a_2,...,a_{k0-1}\}$ to obtain $u_0^{N'}$, a modulo two multiplication operation is performed on $u_0^{N'}$ and the matrix $G_{N'}$ to obtain $y_0^{N'}$, one copy of $y_0^{N'}$ is retained in a buffer, and $y_0^{N'}$ is assigned to $x_0^{N'}$ and is sent.

A frozen bit is inserted into later received $k_1$ information bits $\{a_{k0},a_{k0+1},a_{k0+2},...,a_{k0+k1-1}\}$ to obtain $u_1^{N'}$, a modulo two multiplication operation is performed on $u_1^{N'}$ and the matrix $G_{N'}$ to obtain $y_1^{N'}$. $y_0^{N'}$ is obtained from the buffer, exclusive OR is performed on $y_1^{N'}$ and $y_0^{N'}$ to obtain $x_1^{N'}$, and $x_1^{N'}$ is sent. $x_2^{N'} \sim x_{m-1}^{N'}$ may be obtained and sent by using a same processing procedure for the $k_1$ information bits. After $x_{m-1}^{N'}$ is sent, $y_0^{N'}$ in the buffer is deleted, and the stream encoding process is completed.

(3) Data processing method for implementing stream decoding provided in this application

1. Stream decoding procedure

FIG. 6 is a schematic flowchart of another data processing method according to this application. The data processing method may be performed by a terminal device, or may be performed by a network device. It may be understood that when the terminal device performs the data processing method described in the third part herein, that is, the terminal device is a decoding side, the network device performs the data processing method described in the second part, that is, the network device is an encoding side. When a decoding procedure is performed, the following steps are included.

S201: Receive encoded data, where the encoded data is obtained by encoding an information bit sequence based on an encoding matrix G.

For descriptions of the encoding matrix G, the encoded data, and encoding of the information bit sequence based on the encoding matrix G, refer to the corresponding descriptions in the second part. Details are not described herein again. For example, to support stream decoding, the encoded data may be obtained by encoding the information bit sequence based on the encoding matrix G, or may be obtained by encoding the information bit sequence in the manner described in the case 1 in S102.

S202: Decode the encoded data to obtain decoded data.

A process of decoding the encoded data is a stream decoding procedure. The terminal device may first decode a received $0^{th}$ segment of encoded data and a received $1^{st}$ segment of encoded data. In other words, after receiving a part of information in the decoding process, the terminal device can decode the part of information. Specifically, the following steps may be included.

s11: Obtain marked data corresponding to the $0^{th}$ segment of encoded data and marked data corresponding to the $1^{st}$ segment of encoded data.

s12: Perform an F operation on the marked data corresponding to the $0^{th}$ segment of encoded data and the marked data corresponding to the $1^{st}$ segment of encoded data, to obtain marked data corresponding to the $1^{st}$ segment of encoded data after the F operation.

s13: Perform polar code decoding on the marked data corresponding to the $1^{st}$ segment of encoded data after the F operation, to obtain decoded data corresponding to the $1^{st}$ segment of encoded data.

s14: Enhance, based on the marked data corresponding to the $1^{st}$ segment of encoded data and the decoded data corresponding to the $1^{st}$ segment of encoded data, the marked data corresponding to the $0^{th}$ segment of encoded data.

The marked data corresponding to the $0^{th}$ segment of encoded data is a log likelihood ratio (log likelihood ratio, LLR) of the $0^{th}$ segment of encoded data, and the marked data corresponding to the $1^{st}$ segment of encoded data is an LLR of the $1^{st}$ segment of encoded data. The LLR of the $0^{th}$ segment of encoded data and the LLR of the $1^{st}$ segment of encoded data are used as inputs of an F function, to obtain the marked data corresponding to the $1^{st}$ segment of encoded data after the F operation. For descriptions of the F function, refer to the foregoing descriptions. Details are not described herein again.

For a method for performing polar code decoding on the marked data corresponding to the $1^{st}$ segment of encoded data after the F operation, refer to an existing polar code decoding scheme. This is not limited in this application. The LLR of the $0^{th}$ segment of encoded data, the LLR of the $1^{st}$ segment of encoded data, and the decoded data corresponding to the $1^{st}$ segment of encoded data are used as inputs of a G function, to enhance the marked data corresponding to the $0^{th}$ segment of encoded data, and facilitate stream decoding based on the enhanced $0^{th}$ segment of encoded data in a subsequent decoding process. For descriptions of the G function, refer to the foregoing descriptions. Details are not described herein again.

In a possible implementation, the marked data corresponding to the $0^{th}$ segment of encoded data may be a likelihood probability of the $0^{th}$ segment of encoded data, and the marked data corresponding to the $1^{st}$ segment of encoded data may be a likelihood probability of the $1^{st}$ segment of encoded data. In this case, the foregoing step s12 is changed to: performing a probability operation on the marked data corresponding to the $0^{th}$ segment of encoded data and the marked data corresponding to the $1^{st}$ segment of encoded data, to obtain marked data corresponding to the $1^{st}$ segment of encoded data in a probability domain. It may be understood that a subsequent processing procedure is still performed according to s13 and s14, and the marked data corresponding to the $0^{th}$ segment of encoded data can be enhanced.

Further, for each segment of subsequently received encoded data, a processing manner is similar to that of s11 to s14, and may include the following steps.

s15: Obtain marked data corresponding to a $q^{th}$ segment of encoded data, where q is $2 \leq q \leq m - 1$.

s16: Perform an F operation on the marked data corresponding to the $q^{th}$ segment of encoded data and enhanced marked data corresponding to the $0^{th}$ segment of encoded data, to obtain marked data corresponding to the $q^{th}$ segment of encoded data after the F operation.

s17: Perform polar code decoding on the marked data corresponding to the $q^{th}$ segment of encoded data after the F operation, to obtain decoded data corresponding to the $q^{th}$ segment of encoded data.

s18: Enhance, based on the marked data corresponding to the $q^{th}$ segment of encoded data and the decoded data corresponding to the $q^{th}$ segment of encoded data, the enhanced marked data corresponding to the $0^{th}$ segment of encoded data.

For example, marked data corresponding to a 2nd segment of encoded data is obtained, an F operation is performed on the marked data corresponding to the 2nd segment of encoded data and the enhanced marked data corresponding to the 0th segment of encoded data, to obtain marked data corresponding to the 2nd segment of encoded data after the F operation, polar code decoding is performed on the marked data corresponding to the 2nd segment of encoded data after the F operation, to obtain decoded data corresponding to the 2nd segment of encoded data, and secondary enhancement is performed, based on the marked data corresponding to the 2nd segment of encoded data and the decoded data corresponding to the 2nd segment of encoded data, on enhanced marked data corresponding to the 0th segment of encoded data, to obtain marked data corresponding to the 0th segment of encoded data after the secondary enhancement. For specific implementations of the foregoing steps, refer to specific implementations corresponding to s11 to s14. Details are not described herein again.

It can be learned that, in the data processing method provided in this application, after the encoded data is received, decoding of a part of information may be supported after receiving the part of information in the decoding process, to implement stream decoding, reduce a size of a decoder, and further reduce overheads of the decoding side.

2. Specific example of a stream decoding procedure

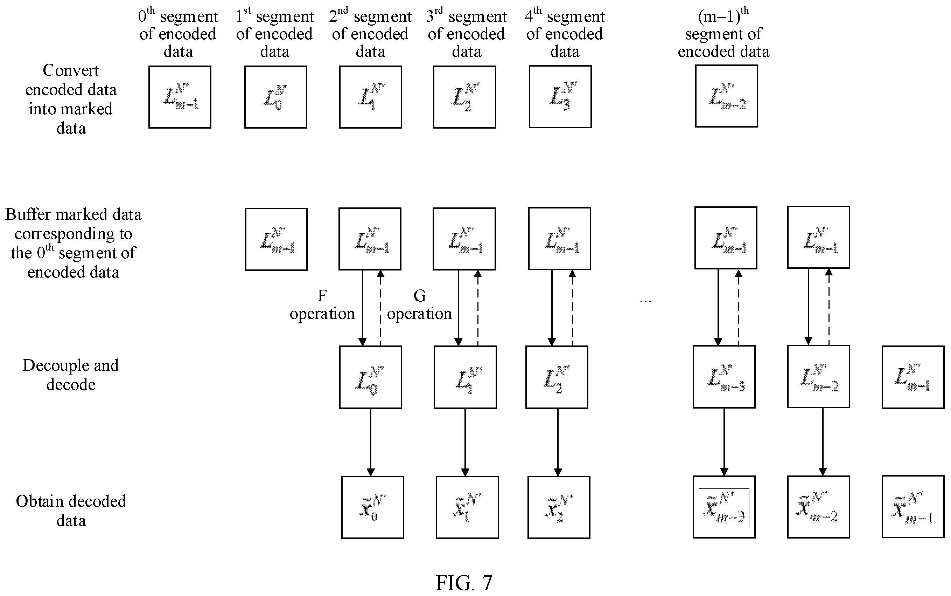

FIG. 7 is a diagram of stream decoding according to this application. When a 0th segment of encoded data (a length is $N' = 2^n$) is received, based on the descriptions in the foregoing embodiments, the 0th segment of encoded data is an (m-1)th piece of buffered data, and the 0th segment of encoded data is marked as $L_{m-1}^{N'}$ and buffered. $L_{m-1}^{N'}$ is an LLR of $x_{m-1}^{N'}$ for sending data, and $x_{m-1}^{N'}$ is $x_{m-1}^{N'}$ to which $y_{m-1}^{N'}$ is assigned for sending described in the third section of the second part.

When a 1st segment of encoded data (a length is $N' = 2^n$) is received, the 1st segment of encoded data is a 0th piece of buffered data, the 1st segment of encoded data is marked as $L_0^{N'}$, an F operation (for example, using an f-function defined for a polar code) is performed on the 1st segment of encoded data and $L_{m-1}^{N'}$ to obtain $\tilde{L}_0^{N'}$, and ordinary polar code decoding is performed on $\tilde{L}_0^{N'}$ to obtain decoded data $\tilde{x}_0^{N'}$. A G operation (for example, using a g-function defined for the polar code) is performed on $\tilde{L}_0^{N'}, L_{m-1}^{N'}, \tilde{x}_0^{N'}$, to obtain enhanced $L_{m-1}^{N'}$.

When a 2nd segment of encoded data (a length is $N' = 2^n$) is received, the 2nd segment of encoded data is a 1st piece of buffered data, the 2nd segment of encoded data is marked as $L_1^{N'}$, an F operation is performed on the 2nd segment of encoded data and $L_{m-1}^{N'}$ to obtain $\tilde{L}_1^{N'}$, and ordinary polar code decoding is performed on $\tilde{L}_1^{N'}$ to obtain decoded data $\tilde{x}_1^{N'}$. A G operation is performed on $\tilde{L}_1^{N'}, L_{m-1}^{N'}, \tilde{x}_1^{N'}$, to obtain secondary-enhanced $L_{m-1}^{N'}$.

It may be understood that, decoded $\tilde{x}_2^{N'} \sim \tilde{x}_{m-2}^{N'}$ may be obtained by using the same method, and $L_{m-1}^{N'}$ that is enhanced a plurality of times may be obtained as decoding is performed. Finally, ordinary polar code decoding is performed on $L_{m-1}^{N'}$ that is enhanced the plurality of times, to obtain decoded data $\tilde{x}_{m-1}^{N'}$, and a stream decoding process is completed.

(4) Performance analysis of a data processing method provided in this application

The performance analysis diagram is a diagram of decoding performance obtained by using a simulation decoder with a code length of $N' = \{128, 512, 2048\}$ and a code rate of $R = 1/8$. A horizontal coordinate of the performance analysis diagram is EsN0 and indicates a ratio of energy of each symbol to a noise power spectral density, and a vertical coordinate is a block error rate (block error rate, BLER), used to measure a system performance test. It may be understood that, by using the stream decoding procedure described in the third part, the decoder can start decoding only after receiving two segments of encoded data (that is, an LLR of $N' \times 2$). Therefore, a size of the decoder may be designed as $N' \times 2$.

A solid line, a first dashed line, and a second dashed line form a group, and may be used to compare differences in decoding performance when decoders with different sizes and a same decoding scheme are used or decoders with a same size and different decoding schemes are used for a same information bit sequence.

First group: The solid line with a diamond-shaped symbol, the first dashed line with the diamond-shaped symbol, and the second dashed line with the diamond-shaped symbol are decoding performance comparison of a first group. It is assumed that a quantity of information bits in an information bit sequence is $K = 64$, and a sending length is $E = K/R = 64/(1/8) = 512$. It is assumed that a decoder size is 256 or 512, and a decoding scheme is existing polar code decoding or stream decoding provided in this application. For example, the first dashed line with the diamond-shaped symbol indicates decoding performance when the sending length E=512, the decoder size is 512, the quantity of information bits is $K = 64$, and existing polar code decoding is used; the solid line with the diamond-shaped symbol indicates decoding performance when the sending length E=512, the decoder size is 256, the quantity of information bits is $K = 64$, and stream decoding is used; and the second dashed line with the diamond-shaped symbol indicates decoding performance when the sending length E=512, the decoder size is 256, the quantity of information bits is $K = 64$, and existing polar code decoding is used. It can be learned from the comparison of the first group that, in a case of the same EsN0, decoding performance of stream decoding is poorer than decoding performance of an ordinary polar code with a larger decoder (that is, a longer code length), but a decoding side of stream decoding uses a smaller decoder, which significantly reduces overheads of the decoding side. In a case of the same EsN0 and the same decoder size, decoding performance of stream decoding is better than decoding performance of the ordinary polar code.

Second group: The solid line with a square symbol, the first dashed line with the square symbol, and the second dashed line with the square symbol are decoding performance comparison of a second group. It is assumed that a quantity of information bits in an information bit sequence is $K = 256$, and a sending length is $E = K/R = 256/(1/8) = 2048$. It is assumed that a size of a decoder is 1024 or 2048, and a decoding scheme is existing polar code decoding or stream decoding provided in this application. For example, the first dashed line with the square symbol indicates decoding performance when the sending length E=2048, the decoder size is 2048, the quantity of information bits is $K = 256$, and existing polar code decoding is used; the solid line with the square symbol indicates decoding performance when the sending length E=2048, the decoder size is 1024, the quantity of information bits is $K = 256$, and stream decoding is used; and the second dashed line with the square symbol indicates decoding performance when the sending length E=2048, the decoder size is 2048, the quantity of information bits is $K = 256$, and existing polar code decoding is used. It can be learned from the comparison of the second group that, in a case of the same EsN0, decoding performance of stream decoding is poorer than decoding performance of an ordinary polar code with a larger decoder (that is, a longer code length), but a decoding side of stream decoding uses a smaller decoder, which significantly reduces overheads of the decoding side. In a case of the same EsN0 and the same decoder size, decoding performance of stream decoding is better than decoding performance of the ordinary polar code.

Third group: The solid line with an asterisk, the first dashed line with the asterisk, and the second dashed line with the asterisk are decoding performance comparison of a second group. It is assumed that a quantity of information bits in an information bit sequence is $K = 1024$, and a sending length is $E = K/R = 1024/(1/8) = 8192$. It is assumed that a size of a decoder is 4096 or 8192, and a decoding scheme is existing polar code decoding or stream decoding provided in this application. For example, the first dashed line with the square symbol indicates decoding performance when the sending length E=8192, the decoder size is 8192, the quantity of information bits is $K = 1024$, and existing polar code decoding is used; the solid line with the asterisk indicates decoding performance when the sending length E=8192, the decoder size is 4096, the quantity of information bits is $K = 1024$, and stream decoding is used; and the second dashed line with the asterisk indicates decoding performance when the sending length E=8192, the decoder size is 8192, the quantity of information bits is $K = 1024$, and existing polar code decoding is used. It can be learned from the comparison of the third group that, in a case of the same EsN0, decoding performance of stream decoding is poorer than decoding performance of an ordinary polar code with a larger decoder (that is, a longer code length), but a decoding side of stream decoding uses a smaller decoder, which significantly reduces overheads of the decoding side. In a case of the same EsN0 and the same decoder size, decoding performance of stream decoding is better than decoding performance of the ordinary polar code.

To implement the functions in the methods provided in this application, the apparatus or the device provided in this application may include a hardware structure and/or a software module, and implement the foregoing functions in a form of the hardware structure, the software module, or a combination of the hardware structure and the software module. Whether a function in the foregoing functions is performed by using the hardware structure, the software module, or the combination of the hardware structure and the software module depends on particular applications and design constraints of the technical solutions. Division into modules in this application is an example, and is merely logical function division. During actual implementation, another division manner may be used. In addition, functional modules in embodiments of this application may be integrated into one processor, or may exist alone physically, or two or more modules may be integrated into one module. The integrated module may be implemented in a form of hardware, or may be implemented in a form of a software functional module.

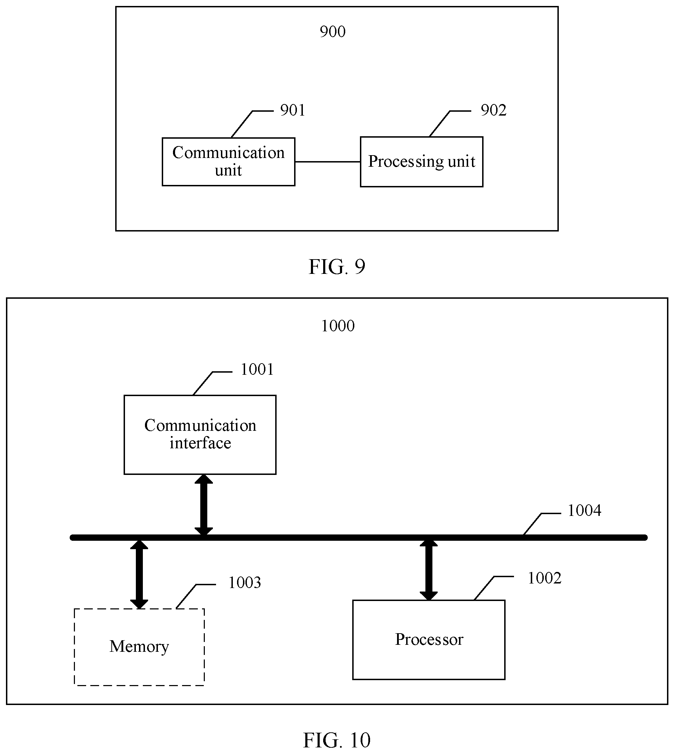

FIG. 9 is a diagram of an apparatus according to this application. The apparatus may include a one-to-one corresponding module for performing the methods/operations/steps/actions described in the method embodiments corresponding to FIG. 3 to FIG. 7. The module may be a hardware circuit, or may be software, or may be implemented by a combination of a hardware circuit and software. For example, the apparatus may be referred to as a data processing apparatus, or may be referred to as a communication apparatus.

The apparatus includes a communication unit 901 and a processing unit 902, configured to implement the method performed by the terminal device or the network device in the foregoing embodiments.

In a possible implementation, the processing unit 902 is configured to obtain an information bit sequence, and encode the information bit sequence based on an encoding matrix $G$ to obtain encoded data. The encoding matrix

$$G = \begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix}$$

, $G$ is a matrix with a size of $(m \times 2^n) \times (m \times 2^n)$, $m$ and $n$ are positive integers, a matrix $G_{N'}$ is a polar generator matrix with a size of $2^n \times 2^n$, and a matrix $O$ is an all-zero matrix with a size of $2^n \times 2^n$. The communication unit 901 is configured to send the encoded data.

Optionally, the information bit sequence includes $m$ segments, and a polar generator matrix of each segment is $G_{N'}$.

Optionally, quantities of information bits in the $m$ segments are $k_0, k_1, ..., k_{m-1}$, where $k_0$ is less than $k_{m-1}$, and $k_0 \leq k_0 \leq ... \leq k_{m-1}$.

Optionally, a quantity of information bits in an $i^{th}$ segment is $k_i$, where $i$ satisfies $0 \leq i \leq m - 1$.

Optionally, the processing unit 902 is configured to obtain $m$ pieces of buffered data, where a $j^{th}$ piece of buffered data is obtained by encoding a $j^{th}$ segment of the information bit sequence by using the matrix $G_{N'}$, and $j$ satisfies $0 \leq j \leq m - 1$; the encoded data includes $m$ segments; a $0^{th}$ segment of encoded data is an $(m-1)^{th}$ piece of buffered data; and an $i^{th}$ segment of encoded data is obtained by performing exclusive OR processing on the $j^h$ piece of buffered data and the $(m-1)^{th}$ piece of buffered data, $i$ satisfies $1 \leq i \leq m - 1$, and $j$ satisfies $0 \leq j \leq m - 2$.

Optionally, the communication unit 901 is configured to first send the $(m-1)^{th}$ piece of buffered data; and then successively send the $i^{th}$ segment of encoded data, where $1 \leq i \leq m-1$.

Optionally, the processing unit 902 is configured to perform elementary column transformation on the encoding

$$G' = \begin{bmatrix} O & G_{N'} & \dots & O \\ O & O & \dots & \dots \\ \dots & \dots & \ddots & G_{N'} \\ G_{N'} & G_{N'} & \dots & G_{N'} \end{bmatrix}$$

matrix $G$, where a transformed encoding matrix ; and encode the information bit sequence based on the transformed encoding matrix $G'$ to obtain the encoded data.

Optionally, quantities of information bits in the $m$ segments are $k_0, k_1, ..., k_{n-1}$, where $k_1$ is less than $k_0$, and $k_1 \leq ... \leq k_{m-1} \leq k_0$.

Optionally, the encoded data includes $m$ segments; a $0^{th}$ segment of encoded data is obtained by encoding a $0^{th}$ segment of the information bit sequence based on the matrix $G_{N'}$; and an $i^{th}$ segment of encoded data is obtained by encoding an $i^{th}$ segment of the information bit sequence based on the matrix $G_{N'}$, and then performing exclusive OR processing on the $i^{th}$ segment and the $0^{th}$ segment of encoded data.

For specific execution procedures of the communication unit 901 and the processing unit 902 in this implementation, refer to the descriptions in the method embodiments corresponding to FIG. 3 to FIG. 7. Details are not described herein again. In the data processing method implemented by the apparatus, a new encoding matrix $G$ of a polar code is designed. When the terminal device encodes to-be-encoded information bits by using the encoding matrix $G$, after receiving a part of information bits in an encoding process, the terminal device may encode the part of information bits and send encoded data, to implement stream encoding and help reduce sizes of an encoder and a buffer in the terminal device. In addition, the to-be-encoded information bits are encoded by using the encoding matrix, to obtain the encoded data, which facilitates stream decoding.

In another possible implementation, the processing unit 902 is configured to obtain an information bit sequence, where the information bit sequence includes $m$ segments, and process each segment by using a polar generator matrix $G_{N'}$ of the segment, to obtain $m$ pieces of buffered data, where the matrix $G_{N'}$ is a polar generator matrix with a size of $2^n \times 2^n$. The processing unit 902 is further configured to obtain encoded data based on the $m$ pieces of buffered data. The encoded data includes $m$ segments, a $0^{th}$ segment of encoded data is an $(m-1)^{th}$ piece of buffered data, an $i^{th}$ segment of encoded data is obtained by performing exclusive OR processing on a $j^{th}$ piece of buffered data and the $(m-1)^{th}$ piece of buffered data, $i$ satisfies $1 \leq i \leq m - 1$, and $j$ satisfies $0 \leq j \leq m - 2$. The communication unit 901 is configured to send the encoded data.

Optionally, quantities of information bits in the $m$ segments are $k_0, k_1, ..., k_{m-1}$, where $k_0$ is less than $k_{m-1}$, and $k_0 \leq k_1$

$\le ... \le k_{m-1}$.

Optionally, a quantity of information bits in an $i^{th}$ segment is $k_i$, where $i$ satisfies $0 \le i \le m$ -1.

Optionally, the processing unit 902 is configured to encode the information bit sequence based on an encoding

$$G = \begin{bmatrix} G_{N'} & O & ... & O \\ O & G_{N'} & ... & O \\ ... & ... & \ddots & ... \\ G_{N'} & G_{N'} & ... & G_{N'} \end{bmatrix}$$

matrix $G$ to obtain the encoded data. The encoding matrix , the encoding matrix $G$ is a matrix with a size of $(m \times 2^n) \times (m \times 2^n)$, $m$ and $n$ are positive integers, the matrix $G_{N'}$ is the polar generator matrix with the size of $2" \times 2"$, and a matrix s an all-zero matrix with a size of $2^n \times 2^n$.

For specific execution procedures of the communication unit 901 and the processing unit 902 in this implementation, refer to the descriptions in the method embodiments corresponding to FIG. 3 to FIG. 7. Details are not described herein again. In the data processing method implemented by the apparatus, the to-be-encoded information bit sequence is divided into the $m$ segments, encoding and information interleaving are performed on each segment by using the polar generator matrix with the size of $2" \times 2"$, and the encoded data is sent in an interleaved manner, to facilitate stream decoding.

In another possible implementation, the processing unit 902 is configured to obtain an information bit sequence, where the information bit sequence includes $m$ segments, and process each segment by using a polar generator matrix $G_{N'}$ of the segment, to obtain encoded data. The matrix $G_{N'}$ is a polar generator matrix with a size of $2^n \times 2^n$, the encoded data includes $m$ segments, a $0^{th}$ segment of encoded data is obtained by encoding a $0^{th}$ segment of the information bit sequence based on the matrix $G_{N'}$, and an $i^{th}$ segment of encoded data is obtained by encoding an $i^{th}$ segment of the information bit sequence based on the matrix $G_{N'}$, and then performing exclusive OR processing on the $i^{th}$ segment and the $0^{th}$ segment of encoded data. The communication unit 901 is configured to send the encoded data.

Optionally, quantities of information bits in the $m$ segments are $k_0, k_1, ..., k_{m-1}$, where $k_0$ is less than $k_0$, and $k_1 \le ... \le k_{m-1} \le k_0$.

Optionally, a quantity of information bits in an $i^{th}$ segment is $k_i$, where $i$ satisfies $0 \le i \le m$ - 1.

Optionally, the processing unit 902 is configured to encode the information bit sequence based on an encoding

$$G' = \begin{bmatrix} O & G_{N'} & ... & O \\ O & O & ... & ... \\ ... & ... & \ddots & G_{N'} \\ G_{N'} & G_{N'} & ... & G_{N'} \end{bmatrix}$$

matrix $G'$ to obtain the encoded data. The encoding matrix , the encoding matrix $G'$ is a matrix with a size of $(m \times 2^n) \times (m \times 2^n)$, $m$ and $n$ are positive integers, the matrix $G_{N'}$ is the polar generator matrix with the size of $2" \times 2"$, and a matrix $O$ is an all-zero matrix with a size of $2^n \times 2^n$.

For specific execution procedures of the communication unit 901 and the processing unit 902 in this implementation, refer to the descriptions in the method embodiments corresponding to FIG. 3 to FIG. 7. Details are not described herein again. In the data processing method implemented by the apparatus, the to-be-encoded information bit sequence is divided into the $m$ segments, and encoding and information interleaving are performed on each segment by using the polar generator matrix with the size of $2" \times 2^n$. In this way, after receiving a part of information in an encoding process, the terminal device can encode and send the part of information (that is, to support stream encoding), to reduce sizes of an encoder and a buffer.

In another possible implementation, the communication unit 901 is configured to receive encoded data, and the processing unit 902 is configured to decode the encoded data to obtain decoded data. The encoded data is obtained by encoding an information bit sequence based on an encoding matrix $G$, the encoding matrix

$$G = \begin{bmatrix} G_{N'} & O & ... & O \\ O & G_{N'} & ... & O \\ ... & ... & \ddots & ... \\ G_{N'} & G_{N'} & ... & G_{N'} \end{bmatrix}$$

, the encoding matrix $G$ is a matrix with a size of $(m \times 2^n) \times (m \times 2^n)$, $m$ and $n$ are positive integers, a matrix $G_{N'}$ is a polar generator matrix with a size of $2" \times 2^n$, and a matrix $O$ is an all-zero matrix with a size of $2^n \times 2^n$.

Optionally, the processing unit 902 is configured to obtain marked data corresponding to a $0^{th}$ segment of encoded data and marked data corresponding to a $1^{st}$ segment of encoded data; perform an F operation on the marked data corresponding to the $0^{th}$ segment of encoded data and the marked data corresponding to the $1^{st}$ segment of encoded data, to obtain marked data corresponding to the $1^{st}$ segment of encoded data after the F operation; perform polar code decoding on the marked data corresponding to the $1^{st}$ segment of encoded data after the F operation, to obtain decoded data corresponding to the $1^{st}$ segment of encoded data; and then enhance, based on the marked data corresponding to the $1^{st}$ segment of encoded data and the decoded data corresponding to the $1^{st}$ segment of encoded data, the marked data corresponding to the $0^{th}$ segment of encoded data.

Optionally, the processing unit 902 is configured to obtain marked data corresponding to a $q^{th}$ segment of encoded data, where $q$ is $2 \leq q \leq m$ - 1; perform an F operation on the marked data corresponding to the $q^{th}$ segment of encoded data and enhanced marked data corresponding to the $0^{th}$ segment of encoded data, to obtain marked data corresponding to the $q^{th}$ segment of encoded data after the F operation; perform polar code decoding on the marked data corresponding to the $q^{th}$ segment of encoded data after the F operation, to obtain decoded data corresponding to the $q^{th}$ segment of encoded data; and enhance, based on the marked data corresponding to the $q^{th}$ segment of encoded data and the decoded data corresponding to the $q^{th}$ segment of encoded data, the enhanced marked data corresponding to the $0^{th}$ segment of encoded data.

For specific execution procedures of the communication unit 901 and the processing unit 902 in this implementation, refer to the descriptions in the method embodiments corresponding to FIG. 3 to FIG. 7. Details are not described herein again. In the data processing method implemented by the apparatus, decoding of a part of information may be supported after the part of information is received in a decoding process, to reduce a size of a decoder.

The following describes a device including a plurality of functional units shown in FIG. 9. The device in this application includes the plurality of functional units shown in FIG. 9. FIG. 10 is a diagram of a communication device according to this application. The communication device is configured to implement the data processing methods in the foregoing method embodiments. The communication device 1000 may alternatively be a chip system. It may be understood that the communication device 1000 may be, for example, a terminal device, or may be a network device.

The communication device 1000 includes a communication interface 1001 and a processor 1002. The communication interface 1001 may be, for example, a transceiver, an interface, a bus, a circuit, or an apparatus that can implement a receiving function and a sending function. The communication interface 1001 is configured to communicate with another device through a transmission medium, so that the device 1000 may communicate with the another device. The processor 1002 is configured to perform a processing-related operation.

In a possible implementation, the processor 1002 is configured to obtain an information bit sequence, and encode the information bit sequence based on an encoding matrix $G$ to obtain encoded data. The encoding matrix

$$G = \begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix}$$

, $G$ is a matrix with a size of $(m \times 2^n) \times (m \times 2^n)$, $m$ and $n$ are positive integers, a matrix $G_{N'}$ is a polar generator matrix with a size of $2^n \times 2^n$, and a matrix $O$ is an all-zero matrix with a size of $2^n \times 2^n$. The communication interface 1001 is configured to send the encoded data.

For specific execution procedures of the communication interface 1001 and the processor 1002 in this implementation, refer to the descriptions in the first aspect and the method embodiments corresponding to FIG. 3 to FIG. 7. Details are not described herein again. In the data processing method implemented by the communication device, a new encoding matrix G of a polar code is designed. When the terminal device encodes to-be-encoded information bits by using the encoding matrix G, after receiving a part of information bits in an encoding process, the terminal device may encode the part of information bits and send encoded data, to implement stream encoding and help reduce sizes of an encoder and a buffer in the terminal device. In addition, the to-be-encoded information bits are encoded by using the encoding matrix, to obtain the encoded data, which facilitates stream decoding.

In another possible implementation, the processor 1002 is configured to obtain an information bit sequence, where the information bit sequence includes $m$ segments, and process each segment by using a polar generator matrix $G_{N'}$, of the segment, to obtain $m$ pieces of buffered data, where the matrix $G_{N'}$ is a polar generator matrix with a size of $2^n \times 2^n$. The processor 1002 is further configured to obtain encoded data based on the $m$ pieces of buffered data. The encoded data includes $m$ segments, a $0^{th}$ segment of encoded data is an $(m$ - $1)^{th}$ piece of buffered data, an $i^{th}$ segment of encoded data is obtained by performing exclusive OR processing on a $j^{th}$ piece of buffered data and the $(m$ - $1)^{th}$ piece of buffered data, $i$ satisfies $1 \leq i \leq m$ - 1, and $j$ satisfies $0 \leq j \leq m$ - 2. The communication interface 1001 is configured to send the encoded data.

For specific execution procedures of the communication interface 1001 and the processor 1002 in this implementation, refer to the descriptions in the second aspect and the method embodiments corresponding to FIG. 3 to FIG. 7. Details are not described herein again. In the data processing method implemented by the communication device, the to-be-encoded information bit sequence is divided into the $m$ segments, encoding and information interleaving are performed on each segment by using the polar generator matrix with the size of $2'' \times 2''$, and the encoded data is sent in an interleaved manner, to facilitate stream decoding.

In another possible implementation, the processor 1002 is configured to obtain an information bit sequence, where the information bit sequence includes $m$ segments, and process each segment by using a polar generator matrix $G_{N'}$ of the segment, to obtain encoded data. The matrix $G_{N'}$ is a polar generator matrix with a size of $2^n \times 2^n$, the encoded data includes $m$ segments, a 0th segment of encoded data is obtained by encoding a 0th segment of the information bit sequence based on the matrix $G_{N'}$, and an $i$th segment of encoded data is obtained by encoding an $i$th segment of the information bit sequence based on the matrix $G_{N'}$, and then performing exclusive OR processing on the $i$th segment and the 0th segment of encoded data. The communication interface 1001 is configured to send the encoded data.

For specific execution procedures of the communication interface 1001 and the processor 1002 in this implementation, refer to the descriptions in the third aspect and the method embodiments corresponding to FIG. 3 to FIG. 7. Details are not described herein again. In the data processing method implemented by the communication device, the to-be-encoded information bit sequence is divided into the $m$ segments, and encoding and information interleaving are performed on each segment by using the polar generator matrix with the size of $2'' \times 2^n$. In this way, after receiving a part of information in an encoding process, the terminal device can encode and send the part of information (that is, to support stream encoding), to reduce sizes of an encoder and a buffer.

In another possible implementation, the communication interface 1001 is configured to receive encoded data, and the processor 1002 is configured to decode the encoded data to obtain decoded data. The encoded data is obtained by encoding an information bit sequence based on an encoding matrix $G$, the encoding matrix

$$G = \begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix}$$

, the encoding matrix $G$ is a matrix with a size of $(m \times 2^n) \times (m \times 2^n)$, $m$ and $n$ are positive integers, a matrix $G_{N'}$ is a polar generator matrix with a size of $2'' \times 2^n$, and a matrix $O$ is an all-zero matrix with a size of $2'' \times 2^n$.

For specific execution procedures of the communication interface 1001 and the processor 1002 in this implementation, refer to the descriptions in the fourth aspect and the method embodiments corresponding to FIG. 3 to FIG. 7. Details are not described herein again. In the data processing method implemented by the communication device, decoding of a part of information may be supported after the part of information is received in a decoding process, to reduce a size of a decoder.

Optionally, the communication device 1000 may further include at least one memory 1003, configured to store program instructions and/or data. In an implementation, the memory is coupled to the processor. The coupling in this application may be an indirect coupling or a communication connection between apparatuses, units, or modules in an electrical form, a mechanical form, or another form, and is used for information exchange between the apparatuses, the units, or the modules. The processor may perform an operation in collaboration with the memory. The processor may execute the program instructions stored in the memory. The at least one memory and the processor are integrated together.

In this application, a specific connection medium between the communication interface, the processor, and the memory is not limited. For example, the memory, the processor, and the communication interface are connected through a bus. The bus 1004 is represented by a thick line in FIG. 10. A manner of a connection between other components is merely an example for description, and is not construed as a limitation. The bus may be classified into an address bus, a data bus, a control bus, and the like. For ease of representation, only one thick line is for representing the bus in FIG. 10, but this does not mean that there is only one bus or only one type of bus.

In this application, the processor may be a general-purpose processor, a digital signal processor, an application-specific integrated circuit, a field programmable gate array or another programmable logic device, a discrete gate or transistor logic device, or a discrete hardware component, and may implement or perform the methods, steps, and logical block diagrams disclosed in this application. The general-purpose processor may be a microprocessor, any conventional processor, or the like. The steps of the methods disclosed with reference to this application may be directly implemented by a hardware processor, or may be implemented by a combination of hardware and a software module in a processor.

In this application, the memory may be a non-volatile memory, for example, a hard disk drive (hard disk drive, HDD) or a solid-state drive (solid-state drive, SSD), or may be a volatile memory (volatile memory), for example, a random access memory (random access memory, RAM). The memory is any other medium that can carry or store expected program code in a form of an instruction structure or a data structure and that can be accessed by a computer, but is not limited thereto. Alternatively, the memory in this application may be a circuit or any other apparatus that can implement a storage function, and is configured to store program instructions and/or data.

This application provides a communication apparatus. The communication apparatus includes an input/output interface and a logic circuit. The input/output interface is configured to input or output data. The logic circuit processes the data according to the methods in the embodiments corresponding to FIG. 3 to FIG. 7, to obtain processed data.

This application provides a communication apparatus. The communication apparatus includes an input/output interface and a logic circuit. The input/output interface is configured to input or output data. The logic circuit processes the data according to the methods in the embodiments corresponding to FIG. 3 to FIG. 7, to obtain processed data.

This application provides a communication system. The communication system includes the terminal device and the network device in the embodiments corresponding to FIG. 3 to FIG. 7.

This application provides a computer-readable storage medium. The computer-readable storage medium stores a program or instructions. When the program or the instructions are run on a computer, the computer is enabled to perform the data processing methods in the embodiments corresponding to FIG. 3 to FIG. 7.

This application provides a computer program product. The computer program product includes instructions. When the instructions are run on a computer, the computer is enabled to perform the data processing methods in the embodiments corresponding to FIG. 3 to FIG. 7.

This application provides a chip or a chip system. The chip or the chip system includes at least one processor and an interface. The interface and the at least one processor are interconnected through a line. The at least one processor is configured to run a computer program or instructions, to perform the data processing methods in the embodiments corresponding to FIG. 3 to FIG. 7.

The interface in the chip may be an input/output interface, a pin, a circuit, or the like.

The chip system may be a system on chip (system on chip, SoC), or may be a baseband chip, or the like. The baseband chip may include a processor, a channel encoder, a digital signal processor, a modem, an interface module, and the like.

In an implementation, the chip or the chip system described above in this application further includes at least one memory, and the at least one memory stores instructions. The memory may be a storage unit inside the chip, for example, a register or a buffer, or may be a storage unit (for example, a read-only memory or a random access memory) of the chip.

All or some of the technical solutions provided in this application may be implemented by using software, hardware, firmware, or any combination thereof. When software is used to implement embodiments, all or some of embodiments may be implemented in a form of a computer program product. The computer program product includes one or more computer instructions. When the computer program instructions are loaded and executed on a computer, the procedure or functions according to this application are all or partially generated. The computer may be a general-purpose computer, a dedicated computer, a computer network, a network device, a terminal device, or another programmable apparatus. The computer instructions may be stored in a computer-readable storage medium, or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible to the computer, or a data storage device, for example, a server or a data center, integrating one or more usable media. The usable medium may be a magnetic medium (for example, a floppy disk, a hard disk, or a magnetic tape), an optical medium (for example, a digital video disc (digital video disc, DVD)), a semiconductor medium, or the like.

In this application, on the premise that there is no logical conflict, embodiments may be mutually referenced. For example, methods and/or terms in the method embodiments may be mutually referenced. For example, functions and/or terms in the apparatus embodiments may be mutually referenced. For example, functions and/or terms in the apparatus embodiments and the method embodiments may be mutually referenced.

It is clear that a person skilled in the art can make various modifications and variations to this application without departing from the scope of this application. This application is intended to cover these modifications and variations of this application provided that they fall within the scope of protection defined by the following claims and their equivalent technologies.

## Claims

1. A data processing method, comprising:

    obtaining an information bit sequence;
    encoding the information bit sequence based on an encoding matrix G to obtain encoded data, wherein

$$G = \begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix}$$

the encoding matrix , G is a matrix with a size of $(m \times 2^n) \times (m \times 2^n)$, $m$ and $n$ are positive integers,

the matrix $G_{N'}$ is a polar generator matrix with a size of $2^n \times 2^n$, and

the matrix O is an all-zero matrix with a size of $2^n \times 2^n$; and

sending the encoded data.

2. The method according to claim 1, wherein
   the information bit sequence comprises $m$ segments, and a polar generator matrix of each segment is $G_{N'}$.

3. The method according to claim 2, wherein

   quantities of information bits in the $m$ segments are $k_0, k_1, ..., k_{m-1}$, wherein
   $k_0$ is less than $k_{m-1}$, and $k_0 \leq k_1 \leq ... \leq k_{m-1}$.

4. The method according to claim 2 or 3, wherein
   a quantity of information bits in an $i^{th}$ segment is $k_i$, wherein $i$ satisfies $0 \leq i \leq m-1$.

5. The method according to claim 4, wherein the encoding the information bit sequence based on an encoding matrix $G$ to obtain encoded data comprises:

   obtaining $m$ pieces of buffered data, wherein a $j^{th}$ piece of buffered data is obtained by encoding a $j^{th}$ segment of the information bit sequence by using the matrix $G_{N'}$, and $j$ satisfies $0 \leq j \leq m-1$;
   the encoded data comprises $m$ segments;
   a $0^{th}$ segment of encoded data is an $(m-1)^{th}$ piece of buffered data; and
   an $i^{th}$ segment of encoded data is obtained by performing exclusive OR processing on the $j^{th}$ piece of buffered data and the $(m-1)^{th}$ piece of buffered data, $i$ satisfies $1 \leq i \leq m-1$, and $j$ satisfies $0 \leq j \leq m-2$.

6. The method according to any one of claims 2 to 5, wherein the sending the encoded data comprises:

   sending the $(m-1)^{th}$ piece of buffered data; and
   successively sending the $i^{th}$ segment of encoded data, wherein $i$ satisfies $1 \leq i \leq m-1$.

7. The method according to claim 1, wherein the method further comprises:

   performing elementary column transformation on the encoding matrix G, wherein a transformed encoding matrix

$$G' = \begin{bmatrix} O & G_{N'} & \dots & O \\ O & O & \dots & \dots \\ \dots & \dots & \ddots & G_{N'} \\ G_{N'} & G_{N'} & \dots & G_{N'} \end{bmatrix}$$

; and
   encoding the information bit sequence based on the transformed encoding matrix G' to obtain the encoded data.

8. The method according to claim 2 or 7, wherein

   quantities of information bits in the $m$ segments are $k_0, k_1, ..., k_{m-1}$, wherein
   $k_1$ is less than $k_0$, and $k_1 \leq ... \leq k_{m-1} \leq k_0$.

9. The method according to claim 8, wherein

   the encoded data comprises $m$ segments;
   a $0^{th}$ segment of encoded data is obtained by encoding a $0^{th}$ segment of the information bit sequence based on the matrix $G_{N'}$; and
an $i^{th}$ segment of encoded data is obtained by encoding an $i^{th}$ segment of the information bit sequence based on the matrix $G_{N'}$ and then performing exclusive OR processing on the $i^{th}$ segment and the $0^{th}$ segment of encoded data.

10. A data processing method, comprising:

receiving encoded data, wherein the encoded data is obtained by encoding an information bit sequence based on an encoding matrix $G$,

$$G = \begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix}$$

the encoding matrix, the encoding matrix $G$ is a matrix with a size of $(m \times 2^n) \times (m \times 2^n)$, $m$ and $n$ are positive integers,
the matrix $G_{N'}$ is a polar generator matrix with a size of $2^n \times 2^n$, and
the matrix $O$ is an all-zero matrix with a size of $2^n \times 2^n$; and
decoding the encoded data to obtain decoded data.

11. The method according to claim 10, wherein
the information bit sequence comprises $m$ segments, and a polar generator matrix of each segment is $G_{N'}$.

12. The method according to claim 10 or 11, wherein the decoding the encoded data to obtain decoded data comprises:

obtaining marked data corresponding to a $0^{th}$ segment of encoded data and marked data corresponding to a $1^{st}$ segment of encoded data;
performing an F operation on the marked data corresponding to the $0^{th}$ segment of encoded data and the marked data corresponding to the $1^{st}$ segment of encoded data, to obtain marked data corresponding to the $1^{st}$ segment of encoded data after the F operation;
performing polar code decoding on the marked data corresponding to the $1^{st}$ segment of encoded data after the F operation, to obtain decoded data corresponding to the $1^{st}$ segment of encoded data; and
enhancing, based on the marked data corresponding to the $1^{st}$ segment of encoded data and the decoded data corresponding to the $1^{st}$ segment of encoded data, the marked data corresponding to the $0^{th}$ segment of encoded data.

13. The method according to claim 12, wherein the method further comprises:

obtaining marked data corresponding to a $q^{th}$ segment of encoded data, wherein $q$ is $2 \leq q \leq m-1$;
performing an F operation on the marked data corresponding to the $q^{th}$ segment of encoded data and enhanced marked data corresponding to the $0^{th}$ segment of encoded data, to obtain marked data corresponding to the $q^{th}$ segment of encoded data after the F operation;
performing polar code decoding on the marked data corresponding to the $q^{th}$ segment of encoded data after the F operation, to obtain decoded data corresponding to the $q^{th}$ segment of encoded data; and
enhancing, based on the marked data corresponding to the $q^{th}$ segment of encoded data and the decoded data corresponding to the $q^{th}$ segment of encoded data, the enhanced marked data corresponding to the $0^{th}$ segment of encoded data.

14. A data processing method, comprising:

obtaining an information bit sequence, wherein the information bit sequence comprises $m$ segments;
processing each segment by using a polar generator matrix $G_{N'}$ of the segment, to obtain $m$ pieces of buffered data, wherein
the matrix $G_{N'}$ is a polar generator matrix with a size of $2^n \times 2^n$;
obtaining encoded data based on the $m$ pieces of buffered data; and
sending the encoded data, wherein
the encoded data comprises $m$ segments, a $0^{th}$ segment of encoded data is an $(m-1)^{th}$ piece of buffered data, an $i^{th}$

segment of encoded data is obtained by performing exclusive OR processing on a $j^{th}$ piece of buffered data and the $(m-1)^{th}$ piece of buffered data, $i$ satisfies $1 \leq i \leq m-1$, and $j$ satisfies $0 \leq j \leq m-2$.

15. The method according to claim 14, wherein

quantities of information bits in the $m$ segments are $k_0, k_1, ..., k_{m-1}$, wherein $k_0$ is less than $k_{m-1}$, and $k_0 \leq k_1 \leq ... \leq k_{m-1}$.

16. The method according to claim 15, wherein a quantity of information bits in an $i^{th}$ segment is $k_i$, wherein $i$ satisfies $0 \leq i \leq m-1$.

17. The method according to any one of claims 14 to 16, wherein the obtaining encoded data comprises:

encoding the information bit sequence based on an encoding matrix 
$$G = \begin{bmatrix} G_{N'} & O & ... & O \\ O & G_{N'} & ... & O \\ ... & ... & \ddots & ... \\ G_{N'} & G_{N'} & ... & G_{N'} \end{bmatrix}$$
to obtain the encoded data, wherein
$G$ is a matrix with a size of $(m \times 2^n) \times (m \times 2^n)$, $m$ and $n$ are positive integers,
the matrix $G_{N'}$ is the polar generator matrix with the size of $2^n \times 2^n$, and
the matrix O is an all-zero matrix with a size of $2^n \times 2^n$.

18. A data processing method, comprising:

obtaining an information bit sequence, wherein the information bit sequence comprises $m$ segments;
processing each segment by using a polar generator matrix $G_{N'}$ of the segment, to obtain encoded data; and
sending the encoded data, wherein
the matrix $G_{N'}$ is a polar generator matrix with a size of $2^n \times 2^n$; and
the encoded data comprises $m$ segments, a $0^{th}$ segment of encoded data is obtained by encoding a $0^{th}$ segment of the information bit sequence based on the matrix $G_{N'}$, and an $i^{th}$ segment of encoded data is obtained by encoding an $i^{th}$ segment of the information bit sequence based on the matrix $G_{N'}$, and then performing exclusive OR processing on the $i^{th}$ segment and the $0^{th}$ segment of encoded data.

19. The method according to claim 18, wherein

quantities of information bits in the $m$ segments are $k_0, k_1, ..., k_{m-1}$, wherein $k_1$ is less than $k_0$, and $k_1 \leq ... \leq k_{m-1} \leq k_0$.

20. The method according to claim 18 or 19, wherein the obtaining encoded data comprises:

encoding the information bit sequence based on an encoding matrix 
$$G' = \begin{bmatrix} O & G_{N'} & ... & O \\ O & O & ... & ... \\ ... & ... & \ddots & G_{N'} \\ G_{N'} & G_{N'} & ... & G_{N'} \end{bmatrix}$$
to obtain the encoded data, wherein
$G'$ is a matrix with a size of $(m \times 2^n) \times (m \times 2^n)$, $m$ and $n$ are positive integers,
the matrix $G_{N'}$ is the polar generator matrix with the size of $2^n \times 2^n$, and
the matrix $O$ is an all-zero matrix with a size of $2^n \times 2^n$.

21. A data processing apparatus, comprising a unit or a module configured to perform the method according to any one of claims 1 to 20.

22. A communication device, comprising a memory and a processor, wherein

the memory is configured to store instructions; and

the processor is configured to execute the instructions, so that the method according to any one of claims 1 to 20 is performed.

23. A communication system, comprising:

a transmitting end, configured to perform the method according to any one of claims 1 to 9, 14 to 17, or 18 to 20; and

a receiving end, configured to perform the method according to any one of claims 10 to 13.

24. A chip, comprising a processor and an interface, wherein

the processor is configured to read instructions to perform the method according to any one of claims 1 to 20.

25. A communication apparatus, wherein the communication apparatus comprises an input/output interface and a logic circuit, the input/output interface is configured to input or output data, and the logic circuit processes the data according to the method according to any one of claims 1 to 9, 14 to 17, or 18 to 20, to obtain processed data.

26. A communication apparatus, wherein the communication apparatus comprises an input/output interface and a logic circuit, the input/output interface is configured to input or output data, and the logic circuit processes the data according to the method according to any one of claims 10 to 13, to obtain processed data.

27. A computer-readable storage medium, comprising a program or instructions, wherein when the program or the instructions are run on a computer, the method according to any one of claims 1 to 20 is performed.

FIG. 1

FIG. 2

Obtain an information bit sequence — S101

Encode the information bit sequence based on an encoding matrix $G$ to obtain encoded data — S102

Send the encoded data — S103

FIG. 3

Divide an information bit sequence into $m$ segments, and insert a frozen bit

$u_0^{N'}$    $u_1^{N'}$    $u_2^{N'}$    $\cdots$    $u_{m-1}^{N'}$

Perform a modulo two multiplication operation on each segment and a matrix $G_{N'}$

$y_0^{N'}$    $y_1^{N'}$    $y_2^{N'}$    $\cdots$    $y_{m-1}^{N'}$

$x_0^{N'}$    $x_1^{N'}$    $x_2^{N'}$    $\cdots$    $x_{m-1}^{N'}$

$x_{m-1}^{N'}$    $x_0^{N'}$    $x_1^{N'}$    $x_2^{N'}$    $\cdots$    $x_{m-2}^{N'}$

Sending order

FIG. 4

Processing procedure

Time order

Obtain an information bit sequence

0<sup>th</sup> segment    1<sup>st</sup> segment    1<sup>st</sup> segment      (m−1)<sup>th</sup> segment

$k_0$    $k_1$    $k_2$    $\cdots$    $k_{m-2}$    $k_{m-1}$    Information bit sequence

Insert a frozen bit into a segment, and perform a modulo two multiplication operation on the segment and a matrix $G_{N'}$

$y_0^{N'}$    $y_1^{N'}$    $y_2^{N'}$    $\cdots$    $y_{m-2}^{N'}$    $y_{m-1}^{N'}$

Buffer and/or perform exclusive OR

Generate and send encoded data

$x_0^{N'}$    $x_1^{N'}$    $x_2^{N'}$    $\cdots$    $x_{m-2}^{N'}$    $x_{m-1}^{N'}$

FIG. 5

Receive encoded data, where the encoded data is obtained by encoding an information bit sequence based on an encoding matrix $G$    S201

Decode the encoded data to obtain decoded data    S202

FIG. 6

Convert encoded data into marked data

$0^{th}$ segment of encoded data $\quad$ $1^{st}$ segment of encoded data $\quad$ $2^{nd}$ segment of encoded data $\quad$ $3^{rd}$ segment of encoded data $\quad$ $4^{th}$ segment of encoded data $\quad$ $(m-1)^{th}$ segment of encoded data

$$L_{m-1}^{N'} \quad L_0^{N'} \quad L_1^{N'} \quad L_2^{N'} \quad L_3^{N'} \quad L_{m-2}^{N'}$$

Buffer marked data corresponding to the $0^{th}$ segment of encoded data

$$L_{m-1}^{N'} \quad L_{m-1}^{N'} \quad L_{m-1}^{N'} \quad L_{m-1}^{N'} \quad L_{m-1}^{N'} \quad L_{m-1}^{N'}$$

F operation $\quad$ G operation $\quad$ ...

Decouple and decode

$$L_0^{N'} \quad L_1^{N'} \quad L_2^{N'} \quad L_{m-3}^{N'} \quad L_{m-2}^{N'} \quad L_{m-1}^{N'}$$

Obtain decoded data

$$\tilde{x}_0^{N'} \quad \tilde{x}_1^{N'} \quad \tilde{x}_2^{N'} \quad \tilde{x}_{m-3}^{N'} \quad \tilde{x}_{m-2}^{N'} \quad \tilde{x}_{m-1}^{N'}$$

FIG. 7

Code rate R=1/8

Block error rate

Legend:
- --□-- E=512, N=512, and K=64 for existing polar code decoding
- ····□··· E=512, N=256, and K=64 for existing polar code decoding
- ──□── E=512, N=256, and K=64 for stream decoding provided in this application
- --◇-- E=2048, N=2048, and K=256 for existing polar code decoding
- ····◇··· E=2048, N=1024, and K=256 for existing polar code decoding
- ──◇── E=2048, N=1024, and K=256 for stream decoding provided in this application
- --★-- E=8192, N=8192, and K=1024 for existing polar code decoding
- ····★··· E=8192, N=4096, and K=1024 for existing polar code decoding
- ──★── E=8192, N=4096, and K=1024 for stream decoding provided in this application

EsN0: indicates a ratio of energy of each symbol to a noise power spectral density

FIG. 8

EP 4 564 684 A1

900

901

Communication unit

902

Processing unit

FIG. 9

1000

1001

Communication interface

1004

1003

Memory

1002

Processor

FIG. 10

## INTERNATIONAL SEARCH REPORT

| International application No. |
| --- |
| **PCT/CN2022/110968** |

| A. | CLASSIFICATION OF SUBJECT MATTER |
| --- | --- |

H03M 7/40(2006.01)i

According to International Patent Classification (IPC) or to both national classification and IPC

| B. | FIELDS SEARCHED |
| --- | --- |

Minimum documentation searched (classification system followed by classification symbols)

H03M

Documentation searched other than minimum documentation to the extent that such documents are included in the fields searched

Electronic data base consulted during the international search (name of data base and, where practicable, search terms used)

CNKI, CNPAT, WPI, EPODOC, IEEE: 极化, 编码, 分段, 分块, 子矩阵, 全零矩阵, 编码矩阵, 生成矩阵, 信息比特, 缓存, 异或, polar, code, segment, block, sub-matrix, all zero matrix, coding matrix, generation matrix, information bits, buffer, cache, XOR, exclusive OR

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | CN 113541698 A (HUAWEI TECHNOLOGIES CO., LTD.) 22 October 2021 (2021-10-22) description, paragraphs 0281-0430 | 1-27 |
| A | CN 114337686 A (CHINA TELECOM CORP., LTD.) 12 April 2022 (2022-04-12) description, paragraphs 0056-0076 | 14-25, 27 |
| A | CN 108462560 A (XIDIAN UNIVERSITY) 28 August 2018 (2018-08-28) entire document | 1-27 |
| A | CN 113055023 A (UNIVERSITY OF SCIENCE AND TECHNOLOGY BEIJING) 29 June 2021 (2021-06-29) entire document | 1-27 |
| A | CN 110535558 A (ZTE CORP.) 03 December 2019 (2019-12-03) entire document | 1-27 |
| A | WO 2018172699 A1 (ORANGE) 27 September 2018 (2018-09-27) entire document | 1-27 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **14 December 2022** | **21 December 2022** |

| Name and mailing address of the ISA/CN | Authorized officer |
| --- | --- |
| **China National Intellectual Property Administration (ISA/CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT
### Information on patent family members

International application No.

**PCT/CN2022/110968**

| Patent document cited in search report | | | Publication date (day/month/year) | Patent family member(s) | | | Publication date (day/month/year) |
|---|---|---|---|---|---|---|---|
| CN | 113541698 | A | 22 October 2021 | WO | 2021213219 | A1 | 28 October 2021 |
| CN | 114337686 | A | 12 April 2022 | None | | | |
| CN | 108462560 | A | 28 August 2018 | None | | | |
| CN | 113055023 | A | 29 June 2021 | None | | | |
| CN | 110535558 | A | 03 December 2019 | WO | 2021012727 | A1 | 28 January 2021 |
| WO | 2018172699 | A1 | 27 September 2018 | FR | 3064436 | A1 | 28 September 2018 |

Form PCT/ISA/210 (patent family annex) (January 2015)